# FASCICULE DE BREVET EUROPEEN

(11) **EP 3 146 558 B1**
(45) Date de publication et mention de la délivrance du brevet: **13.09.2023**
(21) Numéro de dépôt: 15725563.9
(22) Date de dépôt: 20.05.2015
(51) Int. Cl.: H01L 21/20, H01L 33/16, C30B 25/04, C30B 25/18, C30B 29/40

(54) **PROCEDE DE FABRICATION D'UN MATERIAU SEMI-CONDUCTEUR INCLUANT UNE COUCHE DE NITRURE D'ELEMENT III SEMI-POLAIRE**
VERFAHREN ZUR HERSTELLUNG EINES HALBLEITERMATERIALS MIT EINER HALBPOLAREN III-NITRID-SCHICHT
METHOD FOR MANUFACTURING A SEMICONDUCTOR MATERIAL INCLUDING A SEMI-POLAR III-NITRIDE LAYER

(30) Priorité: 20.05.2014 FR 1454507
(43) Date de publication de la demande: 29.03.2017
(73) Titulaire: Centre National de la Recherche Scientifique (C.N.R.S.), 75016 Paris (FR)
(72) Inventeur: DE MIERRY, Philippe, F-06560 Valbonne (FR); TENDILLE, Florian, F-06250 Mougins (FR); VENNEGUES, Philippe, F-06600 Antibes (FR)
(74) Mandataire: Brevalex
(86) Numéro de dépôt international: PCT/EP2015/061132
(87) Numéro de publication internationale: WO 2015/177220

(56) Documents cités:
- GB-A- 2 502 818
- OKADA N ET AL: "Growth of semipolar (1122) GaN layer by controlling anisotropic growth rates in r-plane patterned sapphire substrate", APPLIED PHYSICS EXPRESS JAPAN SOCIETY OF APPLIED PHYSICS THROUGH THE INSTITUTE OF PURE AND APPLIED PHYSICS JAPAN, vol. 2, no. 9, 2009, XP002734976, ISSN: 1882-0778
- SCHWAIGER S ET AL: "Growth and coalescence behavior of semipolar (1122) GaN on pre-structured r-plane sapphire substrates", PHYSICA STATUS SOLIDI B WILEY-VCH VERLAG GMBH GERMANY, vol. 248, no. 3, mars 2011 (2011-03), pages 588-593, XP002734977, ISSN: 0370-1972

## Description

### DOMAINE TECHNIQUE

L'invention concerne le domaine technique général de la fabrication d'un matériau semi-conducteur incluant une couche semi-polaire de nitrure d'éléments de la colonne III du tableau périodique - telle qu'une couche de nitrure de gallium.

Notamment, la présente invention concerne la fabrication de plaquettes de matériau semi-conducteur - ou « wafer » selon la terminologie anglo-saxonne - de grande surface et incluant une couche de nitrure de gallium semi-polaire.

Un tel matériau semi-conducteur peut être destiné à la réalisation de structures semi-conductrices telles que des diodes électroluminescentes (DEL) ou des diodes laser (DL).

### PRESENTATION DE L'ART ANTERIEUR

Les matériaux semi-conducteurs à base de nitrures d'éléments III du tableau périodique occupent une place de plus en plus importante dans les domaines de l'électronique et de l'optoélectronique, notamment pour la fabrication de composants semi-conducteurs tels que des diodes électroluminescentes (DEL) ou des diodes laser (DL).

Les procédés actuels de fabrication de matériaux semi-conducteurs à base de nitrure d'élément III reposent sur la technique dite d'hétéro-épitaxie qui consiste à faire croître un cristal - tel qu'un cristal de nitrure de gallium GaN - sur un substrat de départ de nature différente - tel qu'un substrat de saphir.

Toutefois, la technique d'hétéro-épitaxie induit de nombreux défauts cristallins dans la structure de nitrure d'élément III, tels que des dislocations, limitant les performances et la durée de vie des composants à base de nitrure d'élément III.

Ces défauts proviennent de la différence de matériau entre le substrat de départ (sur lequel est mise en oeuvre la croissance de nitrure d'élément III) et la couche de nitrure d'élément III à partir de laquelle est fabriqué le composant semi-conducteur.

Par exemple dans le cas de la fabrication d'une couche de nitrure de gallium (GaN), le substrat de départ généralement utilisé pour la croissance est du saphir dont les paramètres de réseau cristallin (i.e. paramètre de maille) et les paramètres d'expansion thermique sont très différents de ceux du GaN.

L'amélioration des techniques de fabrication permet aujourd'hui de fabriquer des couches de GaN présentant un nombre limité de défauts cristallins (densité de dislocation TDD < 5x108 cm-2, où « TDD » est le sigle de l'expression anglo-saxonne « Threading Dislocation Density »).

La plupart des procédés de fabrication actuels permettent d'obtenir des couches de GaN d'orientation C (0001) - dite polaire. En effet, ces procédés de fabrication utilisent des substrats saphir Al2O3 d'orientation C (0001) pour faire croître les couches de GaN.

Les composants optoélectroniques réalisés sur des couches de GaN d'orientation polaire sont soumis à des effets de polarisation dus, entre autre, à la structure hexagonale non idéale du matériau (rapport c/a différent de 1,633) et au caractère ionique de la liaison Ga-N. Ceci diminue considérablement le rendement de ces composants optoélectroniques, tel que le rendement quantique interne d'une diode électroluminescente (DEL) réalisée sur une couche de GaN polaire.

Depuis quelques années, de nombreux groupes de recherche se sont intéressés à d'autres orientations cristallines (orientation semi-polaire) pour éliminer partiellement ces effets de polarisation.

Toutefois, même si la croissance d'une couche de GaN sur un substrat saphir Al2O3 d'orientation différente de C (0001) permet d'obtenir une couche de GaN d'orientation semi-polaire ou non polaire, la qualité cristalline d'une telle couche de GaN semi-polaire n'est pas suffisante pour permettre la fabrication de composants optoélectroniques, notamment du fait de la présence de fautes d'empilement (BSF). Dans le but de diminuer la densité de défauts du GaN semi ou non polaire, la technique de croissance par épitaxie latérale (ELO, de l'anglais epitaxial lateral overgrowth) a été développée, comme décrite dans les articles :
- « Improved quality (1120) a-plane GaN with sidewall lateral epitaxial overgrowth » par Imer B., Wu F., DenBaars S. et Speck J., 2006 Appl. Phys. Lett. 88 061908;
- "Sidewall epitaxial lateral overgrowth of nonpolar a-plane GaN by metalorganic vapor phase epitaxy", par lida D, Kawashima T., Iwaya M., Kamiyama S., Amano H. et Akasaki I., 2008 Phys. Stat. Sol. c 5 1575;
- "Improvements in a-plane GaN crystal quality by a two-step growth process" par Hollander J. L., Kappers M. J., McAleese C. et Humphreys C. J 2008 Appl. Phys. Lett. 92 101104;
- "Improved semipolar (1122) GaN quality using asymmetric lateral epitaxy", par de Mierry P., Kriouche N., Nemoz M. et Nataf G. 2009 Appl. Phys. Lett. 94 191903.

De même, une technique de croissance par épitaxie localisée (SAG, de l'anglais Sélective Area Growth) à partir de substrats texturés a été développée, comme décrit dans les articles :
- "Investigation on microstructure in GaN epitaxial growth on the stripe-patterned r-plane sapphire substrates", par Chen H. G., Ko T. S., Chang L., Wu Y. H., Lu T. C., Kuo H. C. et Wang S. C. 2008 J. Cryst. Growth 310 1627;
- "Growth and coalescence behavior of semipolar (1122) GaN on pre-structured r-plane sapphire substrates", par Schwaiger S., Metzner S., Wunderer T., Argut I., Thalmair J., Lipski F., Wieneke M., Blasing J., Bertram F., Zweck J., Krost A., Christen J. et Scholz F. 2011 Phys. Stat.

Sol. b 248 - 588 (document considéré comme l'état de l'art le plus proche de l'objet de l'invention). Ce document, voir particulièrement la figure 5 et le texte associé, décrit un procédé semblable à celui de l'invention, dans lequel les dislocations sont arrêtées par une région de coalescence entre les deux cristaux au lieu d'une cavité.
- "Semipolar GaN films on patterned r-plane sapphire obtained by wet chemical etching", par de Mierry P., Kriouche N., Nemoz M., Chenot S. et Nataf G. 2010 Appl. Phys. Lett. 96 231918;
- "Growth Mechanism of Nonpolar and Semipolar GaN Layers from Sapphire Sidewalls on Various Maskless Patterned Sapphire Substrates", par Okada N., Oshita H., Kurisu A. et Tadatomo K. 2011 Jpn. J. Appl. Phys. 50 035602";
- "A Nonpolar a-Plane GaN Grown on a Hemispherical Patterned r-Plane Sapphire Substrate", par Yoo G., Park H., Lim H., Lee S, Nam O., Moon Y., Lim C., Kong B. et Cho H. 2011 Jpn. J. Appl. Phys. 50 042103;
- "Semipolar GaN grown on foreign substrates: a review", par Scholz F. 2012 Semicond. Sci. Technol. 27 024002;
- "Growth of Semipolar (1122) GaN Layer by Controlling Anisotropic Growth Rates in r-Plane Patterned Sapphire Substrate", par Okada N., Kurisu H. et Tadatomo K. 2009 Appl. Phys. Exp. 2 091001.
Ces techniques, bien qu'apportant des améliorations sur la qualité structurale des couches de GaN semi-polaire, ne permettent pas d'atteindre la qualité du GaN polaire.

A l'instar de ceux-ci, et à titre d'exemple, le document GB 2 502 818 propose de réaliser des nano-piliers afin d'obtenir une croissance latérale et localisée des cristaux de GaN. Par coalescence, ceux-ci se rejoignent en laissant des cavités triangulaires entre le masque et leur point de jonction. Cependant, les défauts se propagent entre les cristaux, et la qualité des couches obtenues n'est pas optimale.

A l'heure actuelle, la seule méthode permettant d'obtenir une couche de GaN semi-polaire, dont la qualité est proche de celle des couches de GaN polaire consiste à :
- faire croître une couche très épaisse de GaN polaire,
- réaliser une découpe transversale de la couche de GaN polaire pour obtenir une tranche de GaN semi-polaire, et
- polir la tranche de GaN semi-polaire.

Cette méthode permet d'obtenir des tranches de GaN semi-polaire de surface comprise entre 1 et 5 cm², ces tranches ayant une qualité sensiblement identique à celle des couches de GaN polaire. Toutefois, les faibles dimensions de ces tranches ne permettent pas une industrialisation de cette méthode.

Un but de la présente invention est de proposer un procédé de fabrication de couches de nitrure d'élément III semi-polaire :
- ayant les mêmes dimensions que les couches de nitrure d'élément III polaire, et
- ayant une qualité sensiblement équivalente voire supérieure à celle des couches de nitrure d'élément III polaire.

### RESUME DE L'INVENTION

A cet effet, l'invention propose un procédé de fabrication d'un matériau semi-conducteur selon la revendication 1 et un matériau semi-conducteur selon la revendication 13.

Des aspects préférés mais non limitatifs du procédé défini dans la revendication 1 sont les suivants :
- le procédé comprend en outre une phase consistant à former des seconds cristaux sur les premiers cristaux, les paramètres de croissance des seconds cristaux de nitrure d'élément III étant adaptés pour favoriser une croissance latérale desdits seconds cristaux de sorte à induire un chevauchement entre les seconds cristaux de nitrure d'élément III adjacents et à former des cavités aux droits des zones de chevauchement des seconds cristaux ;
- la croissance des cristaux de nitrure d'éléments III est réalisée par épitaxie en phase vapeur aux organométalliques EPVOM ou par épitaxie en phase vapeur aux hydrures HVPE, et la formation d'une couche bidimensionnelle de nitrure d'élément III est réalisée par épitaxie en phase vapeur aux organométalliques EPVOM, par épitaxie en phase vapeur aux hydrures HVPE ou par épitaxie par jet moléculaire ;
- le procédé comprend en outre une phase consistant à texturer le substrat de départ, ladite phase incluant une étape consistant à former la pluralité de gorges dans le substrat de départ ;
- l'étape consistant à former la pluralité de gorges comprend les sous-étapes de :
   - dépôt d'un masque de période L2 incluant des ouvertures ;
   - Recuit du substrat de départ comportant le masque à une température supérieure à 900°C sous atmosphère comprenant de l'ammoniac NH3 et/ou un mélange dihydrogène-diazote H2/N2, préalablement à la gravure chimique dans un bain d'acide,
   - gravure du substrat de départ à travers les ouvertures du masque, par introduction du substrat de départ dans un bain d'acide pour former les gorges ;
- la sous-étape de gravure comporte :
   - une gravure sèche du substrat par ions réactifs, précédé ou suivie d'un recuit sous NH3, H2, N2 et
   - une gravure par voie humide du substrat à une température comprise entre 240 et 280°C ;
- les paramètres de l'étape de gravure du substrat sont adaptés pour former des gorges de largeur supérieure aux ouvertures initiales, grâce à l'abrasion latérale sous le masque pour former des zones abrasées, lesdites gorges incluant chacune un premier flanc incliné d'orientation cristallographique C (0001) et un deuxième flanc incliné d'orientation cristallographique différente d'un plan C (0001), par exemple un plan (11̅01) dans le cas du saphir r ;
- les parties du masque surplombant les zones abrasées sont enlevées par une procédure de nettoyage comprenant un traitement dans un bain aux ultrasons, de telle sorte qu'à l'issue de la procédure de nettoyage, le substrat comporte en surface des bandes de masque aux flancs sensiblement verticaux et des gorges ;
- la sous-étape de dépôt d'un masque comprend le dépôt d'une couche de diélectrique, telle qu'une couche de SiOx, ou de SiNx, ou d'une couche métallique, et la gravure du masque, par exemple par photolithographie, pour former les ouvertures ;
- l'épaisseur de la couche de masque est comprise entre 200 nm et 100 micromètres de sorte à bloquer des défauts cristallins générés à partir des flancs inclinés ;
- la phase consistant à former des premiers cristaux comprend les étapes consistant à :
   - déposer une couche tampon de nitrures d'éléments III.
   - recuire thermiquement la couche tampon de sorte à réaliser la migration en phase solide de la couche tampon vers le premier flanc incliné d'orientation C de chaque gorge et ainsi former des premiers germes ;
- l'étape consistant à déposer une couche tampon comprend le dépôt par épitaxie en phase vapeur aux organométalliques EVPOM d'une couche de nitrure d'élément III à une température inférieure à 750°C ;
- l'étape consistant à recuire thermiquement la couche tampon est mise en oeuvre à une température supérieure à 950°C sous atmosphère comprenant de l'hydrogène pour créer des premiers germes d'orientation cristallographique C (0001) sur les premiers flancs des gorges ;
- la phase consistant à former des premiers cristaux comprend une étape consistant à faire croître les premiers cristaux sur les premiers germes ;
- l'étape consistant à faire croître les premiers cristaux est mise en oeuvre à une température comprise entre 900°C et 1300°C, à une pression comprise entre 0,2×10⁵ Pa et 1×10⁵ Pa ;
- la phase consistant à former les premiers cristaux comprend une étape de croissance orientée pour favoriser une vitesse de croissance des premiers cristaux selon des plans cristallographique (0001) supérieure aux vitesses de croissance des premiers cristaux selon les plans perpendiculaires à (0001), tels que des plans cristallographiques (1120) ;
- l'étape de croissance orientée est réalisée à une pression comprise entre 0,03×10⁵ Pa et 0,5×10⁵ Pa, à une température comprise entre 900°C et 1300°C et à un ratio V/III compris entre 250 et 3000 ;
- la phase consistant à former des seconds cristaux de nitrure d'élément III comprend les étapes consistant à :
   - déposer une deuxième couche de SiNx sur les premiers cristaux préexistants, par exposition au silane et NH3, à une température supérieure à 950°C,
   - déposer une deuxième couche tampon de nitrures d'éléments III sur la deuxième couche de SiNx,
   - recuire thermiquement la deuxième couche tampon de sorte à réaliser la migration en phase solide de la couche tampon vers les faces a (1120) et c (0001) des cristaux, et ainsi former des deuxièmes germes ;
- l'étape consistant à déposer une deuxième couche tampon comprend le dépôt par épitaxie en phase vapeur aux organométalliques EVPOM d'une couche de nitrure d'élément III à une température inférieure à 750°C ;
- l'étape consistant à recuire thermiquement la couche tampon est mise en oeuvre à une température supérieure à 950°C sous atmosphère comprenant de l'hydrogène pour créer des deuxièmes germes sur les faces a (1120) et c (0001) des cristaux;
- la phase consistant à former des seconds cristaux comprend une étape consistant à faire croître les seconds cristaux sur les deuxièmes germes ;
- l'étape consistant à faire croître les seconds cristaux est mise en oeuvre à une température comprise entre 900°C et 1300°C, une pression comprise entre 0,2×10⁵ Pa et 1×10⁵ Pa ;
- la phase consistant à former les seconds cristaux comprend une étape de croissance orientée pour favoriser une vitesse de croissance des seconds cristaux selon des plans cristallographique (0001) supérieure aux vitesses de croissance des seconds cristaux selon les plans perpendiculaires à (0001), tels que des plans cristallographiques (1120) ;
- l'étape de croissance orientée est réalisée à une pression comprise entre 0,03×10⁵ Pa et 0,5×10⁵ Pa, à une température comprise entre 900°C et 1300°C, et à un ratio V/III compris entre 250 et 3000 ;
- le substrat de départ est un substrat de saphir d'orientation cristallographique r (11̅02) ;
- le substrat de départ est un substrat de saphir d'orientation cristallographique r (11̅02) possédant une désorientation par rapport au plan nominal pouvant être de plus ou moins 3° ;
- la couche de nitrure d'élément III est une couche de nitrure de gallium d'orientation semipolaire (1122).

L'invention concerne également un matériau semi-conducteur incluant une couche de nitrure d'élément III semi-polaire épitaxiée sur un substrat exogène selon la revendication 13. Le matériau semi-conducteur comporte une couche de nitrure d'élément III semi-polaire incluant des cristaux de nitrure d'élément III coalescés, les cristaux de nitrure d'élément III adjacents se chevauchant.

Des aspects préférés mais non limitatifs du matériau semi-conducteur sont les suivants :
- chaque cavité allongée s'étend dans un plan qui surplombe au moins le plan défini par la facette cristallographique (0001) du substrat ;
- la couche de nitrure d'élément III est caractérisée par une courbe d'intensité de diffraction de rayons X des plans cristallographiques {11-22} en fonction de l'angle d'incidence du faisceau de rayons X sur ces plans présentant une largeur à mi-hauteur inférieure à 400 secondes d'arc ;
- le matériau présente une densité de dislocations inférieure ou égale à 1,3×10⁸ cm⁻², de préférence encore inférieure à 7×10⁷ cm⁻² ;
- le matériau présente une densité de centres non radiatifs mesurée par cathodoluminescence inférieure ou égale à 1,1×10⁸ cm⁻², de préférence encore inférieure à 5×10⁷ cm⁻² ;
- le matériau présente une densité de fautes d'empilements déterminée par une mesure par microscopie électronique en transmission inférieure ou égale à 1×10³ cm⁻¹, de préférence inférieure ou égale à 70 cm⁻¹.

### BREVE DESCRIPTION DES DESSINS

D'autres avantages et caractéristiques du procédé selon l'invention et du produit associé ressortiront mieux de la description qui va suivre de plusieurs variantes d'exécution, données à titre d'exemples non limitatifs, à partir des dessins annexés sur lesquels :
- La figure 1 illustre un exemple de procédé de fabrication d'un matériau semi-conducteur selon l'invention,
- La figure 2a décrit schématiquement les différentes étapes de texturation d'un substrat de départ, notamment un substrat de saphir r, vu en coupe transversale,
- La figure 2b illustre schématiquement un masque en vue de dessus, avant la texturation,
- La figure 3 est une image par microscopie électronique en balayage (MEB) en coupe transversale d'un cristal de GaN semi-polaire d'orientation (112̅2), après 10 minutes de croissance,
- Les figures 4a à 4d illustrent différents exemples de croissance d'une couche de GaN semi-polaire sur un substrat de départ,
- La figure 5 est une image MEB en coupe transversale de cristaux de nitrure d'élément III se chevauchant obtenus après 1h30 de croissance,
- La figure 6 est une image MEB en coupe transversale d'une couche de GaN semi-polaire d'orientation (112̅2) obtenue après coalescence complète des cristaux de la figure 5,
- La figure 7 est un graphique illustrant les spectres de photoluminescence à 14K d'une couche de GaN semi-polaire et d'une couche de GaN polaire,
- Les figures 8a et 8b sont des images de cathodoluminescence à 77K illustrant la luminescence émise sur la tranche (figure 8a) et à la face supérieure (figure 8b,) d'une couche de GaN semi-polaire,
- La figure 9 est une image par microscopie en transmission (TEM) de la surface d'une couche de GaN semi-polaire,
- La figure 10a) est une image TEM d'une zone située à l'aplomb d'une cavité de coalescence formée par la rencontre de deux cristaux adjacents de GaN,
- La figure 10b) est un schéma de principe illustrant la courbure de dislocations dans les premiers stades de croissance d'un cristal de GaN,
- La figure 11a est une image TEM d'une région proche de la facette c.
- La figure 11b est un schéma illustrant le blocage des défauts cristallins par le masque.
- Les figures 12 et 13 sont des images MEB illustrant une couche de GaN incluant une superposition de premier et deuxième cristaux de GaN,
- La figure 14 est une image par cathodoluminescence à 77K de la surface de la couche de GaN correspondant à la figure 13.
- La figure 15 montre la mesure de la largeur à mi-hauteur de l'intensité diffractée par les plans (1122) lorsqu'on incline l'échantillon de part et d'autre d'un axe perpendiculaire aux plans (112̅2).

### DESCRIPTION DETAILLEE DE L'INVENTION

On va maintenant décrire plus en détail des exemples de procédé de fabrication d'un matériau semi-conducteur à base de nitrure d'élément III.

Le procédé sera décrit en référence à la fabrication d'un matériau semi-conducteur incluant une couche de nitrure de gallium (ci-après dénommé « GaN »).

Toutefois, il est bien évident pour l'homme du métier que le procédé décrit ci-après peut être utilisé pour faire croître un matériau incluant une couche de nitrure d'élément III autre que du GaN, tel que tout alliage (Ga, Al, In, B)N, pouvant être utilisé pour réaliser des structures semi-conductrices telles que des diodes électroluminescentes.

### 1. Procédé de fabrication

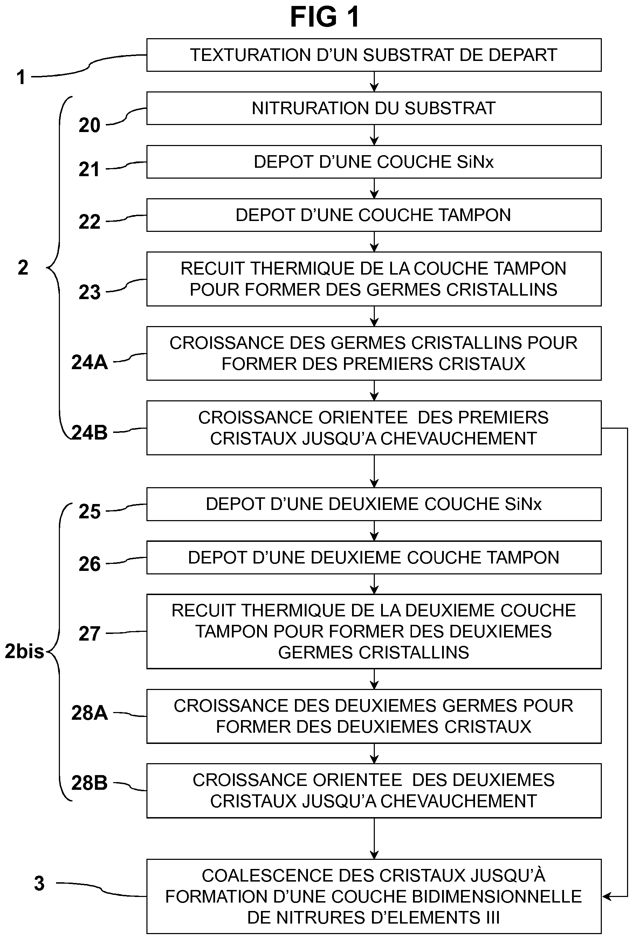

En référence à la figure 1, on a illustré un exemple de procédé de fabrication d'un matériau semi-conducteur incluant une couche de GaN.

Le procédé comprend une phase 1 de texturation d'un substrat de départ de type saphir, une phase 2 de formation de premiers cristaux de GaN à partir du saphir texturé, éventuellement une phase 2bis de formation de seconds cristaux de GaN sur les premiers cristaux de GaN, et une phase 3 de coalescence des (premiers ou deuxièmes) cristaux pour former une couche bidimensionnelle de GaN.

### 1.1. Phase de texturation

Le but de la phase de texturation 1 est de créer des gorges 40 dans le substrat de départ 4, tel qu'un substrat de saphir d'orientation cristallographique r (11̅02). Ce substrat peut éventuellement présenter une désorientation de plus ou moins 3° par rapport à l'orientation nominale.

Ces gorges possèdent des flancs inclinés comprenant au moins une facette permettant la croissance de GaN (0001) selon les relations d'épitaxie connues de l'homme de l'art.

De préférence, ces gorges 40 sont espacées périodiquement. Ceci permet d'obtenir un matériau semi-conducteur incluant une couche de GaN dont les surfaces utiles à la fabrication de structures semi-conductrices sont régulièrement espacées, ce qui facilite la fabrication desdites structures.

Chaque gorge 40 comprend deux flancs 41, 42 inclinés :
- un premier flanc 41 incliné d'orientation cristallographique C (0001) propice à la croissance de GaN (0001), et
- un deuxième flanc 42 incliné d'orientation cristallographique différente (i.e. autre qu'un plan C), par exemple d'orientation cristallographique (11̅01) dans le cas du saphir r.

Le substrat de départ 4 peut être choisi parmi AlN, GaN, GaAs, Al2O3 (saphir), ZnO, SiC, LiAlO2, LiGaO2, MgAl2O4, 4H-SiC, ou tout autre type de substrat de départ connu par l'homme du métier pour mettre en oeuvre une croissance de nitrure de gallium (0001) à partir d'un flanc incliné du substrat. Il peut présenter une épaisseur de quelques centaines de micromètres, généralement 350 micromètres.

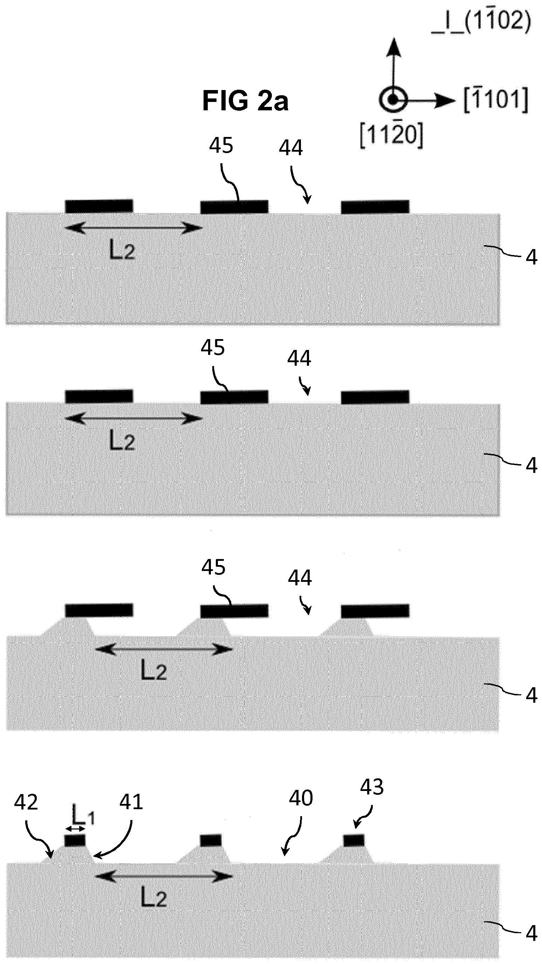

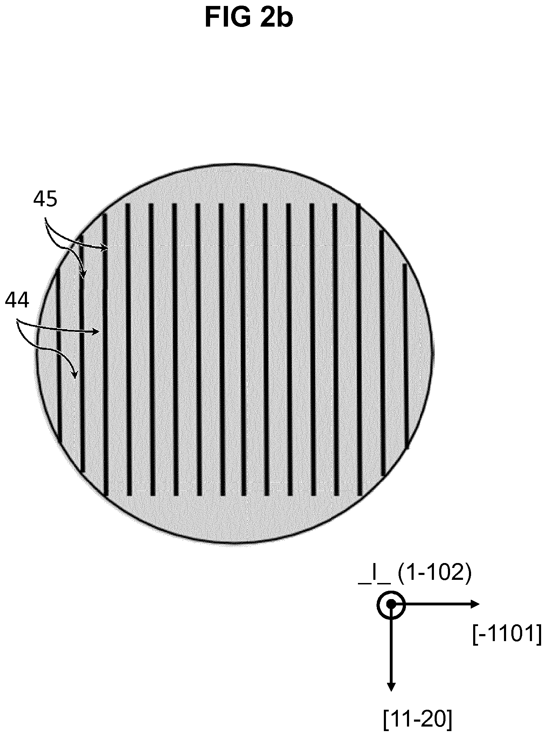

En référence à la figure 2a, la phase de texturation 1 comprend dans une première étape, le dépôt d'un masque 45 sous la forme de bandes, incluant des ouvertures 44, de période L2. Les ouvertures 44 du masque 45 permettent de définir les positions des gorges 40 à créer dans le substrat de départ 4.

Avantageusement, après cette première étape, le substrat peut être recuit à une température supérieure ou égale à 900°C dans un environnement gazeux comprenant (H2, N2, NH3). Ceci a pour effet de favoriser la formation de facettes C (0001) parfaitement orientées (notamment avec un angle de 58° avec la surface du substrat de saphir r) de façon reproductible lors de la gravure chimique.

Le substrat de départ 4 est ensuite gravé à travers les ouvertures 44 pour former les gorges 40. Cette gravure du substrat de départ 4 est par exemple mise en oeuvre par introduction du substrat de départ 4 dans un bain d'acide, par exemple de formule H₃PO₄/ H₂SO₄ en proportion volumique 1 :3 porté à une température de 260°C.

Cette gravure peut aussi être mise en oeuvre par une première gravure sèche de type gravure par ions réactifs RIE (de l'anglais "reactive ion etching") suivie de l'introduction du substrat de départ 4 dans le bain d'acide, par exemple celui précédemment cité, porté à une température comprise entre 240 et 280°C, de préférence 260°C.

La gravure chimique par voie humide entraine une gravure en profondeur en même temps qu'une gravure latérale unidirectionnelle sous le masque, menant à l'apparition de facettes C 41 surplombées d'une casquette de masque rattachée au sommet des gorges, encore dénommés créneaux 43. La largeur des gorges 40 et des créneaux 43 dépend du temps d'abrasion chimique. La distance entre deux facettes C 41 formées au cours de l'étape de gravure demeure constante, égale à L2. La période L2 du masque au départ (avant gravure) permet donc de définir l'espacement entre 2 facettes C, après gravure. La valeur de L2 est par exemple de 10 µm. Le temps nécessaire à la coalescence des germes formés à partir des facettes C dépend de L2. Dans le cas où la croissance est réalisée par épitaxie en phase vapeur aux hydrures (HVPE), les vitesses de croissance élevées permettent d'augmenter L2 jusqu'à au moins 1 mm.

La partie du masque surplombant la zone abrasée (« casquette ») est ensuite enlevée par une procédure de nettoyage qui comprend une exposition du substrat à un bain d'ultrason pendant au moins 1 minute dans un bain pouvant être par exemple de l'eau de-ionisée, de l'acétone ou de l'isopropanol. Les flancs du masque obtenus après cette étape sont abrupts et n'empiètent pas sur les facettes C. L'exposition du substrat à un bain d'ultrasons après la gravure permet d'éliminer les résidus de masque.

A l'issue de la phase de texturation 1, on obtient un substrat de départ 4 texturé comportant des gorges 40, chaque gorge comprenant un premier flanc 41 incliné d'orientation cristalline C (0001) et un deuxième flanc 42 incliné d'orientation cristalline différente (11̅01), les créneaux 43 étant recouverts d'un masque aux bords abrupts et n'empiétant pas sur les flancs du saphir. La présence du masque sur la facette r supérieure du substrat 4 permet d'éviter toute croissance parasite du GaN sur la zone recouverte par le masque 45.

Les gorges 40 présentent un ratio profondeur largeur/largeur inférieur à 1, voire inférieur à 0,1. A titre d'exemple, les gorges 40 de la figure 2a présentent une profondeur de 200 nm pour une largeur de 6000 nm. Ce dimensionnement des gorges 40 permet d'obtenir des facettes de petite dimension. La taille des facettes (0001), liée à la profondeur de la gorge 40, est par exemple de 300 nm, mais peut être avantageusement inférieure à 300 nm afin de diminuer la surface de nucléation qui peut induire des défauts, et est de préférence au moins égale à 200 nm, mais peut être inférieure. L'abrasion chimique permet d'obtenir des facettes de petite dimension.

Le masque 45 peut être un masque en matériau diélectrique ou métallique. Lorsque le masque 45 est un masque diélectrique, le matériau le constituant est de préférence du type SiNx (SiN, Si₃N₄, etc.) ou SiO₂ ou TiN. Ceci permet de minimiser les défauts créés en bord de masque et améliore ainsi la qualité de la couche de nitrure de gallium épitaxiée ultérieurement sur celui-ci. Lorsque le masque 45 est un masque métallique, le matériau le constituant est de préférence du type Tungstène (W) ou Molybdène (Mo) ou Chrome (Cr). (A noter que dans ce cas, le métal devra être protégé par un diélectrique lors de la gravure dans un bain d'acide).

Lorsque le masque est du type SiNx, le dépôt du masque 45 peut être réalisé dans une chambre de croissance du GaN à partir de silane et d'ammoniac directement sur le substrat de départ. Ce dépôt du masque peut être réalisé par toute autre technique connue de l'homme du métier.

Par exemple, dans un mode de réalisation l'étape de dépôt du masque 45 (diélectrique ou métallique) comprend :
- le dépôt d'une couche (de diélectrique ou de métal) sur toute la surface du support de croissance, et
- la gravure de la couche (de diélectrique ou de métal) - notamment par photolithographie - de façon à définir les ouvertures dans la couche (de diélectrique ou de métal) exposant des régions micrométriques de la surface du substrat de départ.

Les ouvertures 44 définies lors de la gravure peuvent être ponctuelles ou sous forme de bandes. Avantageusement, les ouvertures 44 ponctuelles peuvent être inscrites dans un cercle de rayon inférieur à 10 micromètres, tandis que les ouvertures 44 en forme de bande ont une largeur inférieure à 10 micromètres, la longueur des bandes n'étant limitée que par les dimensions du substrat de départ 4.

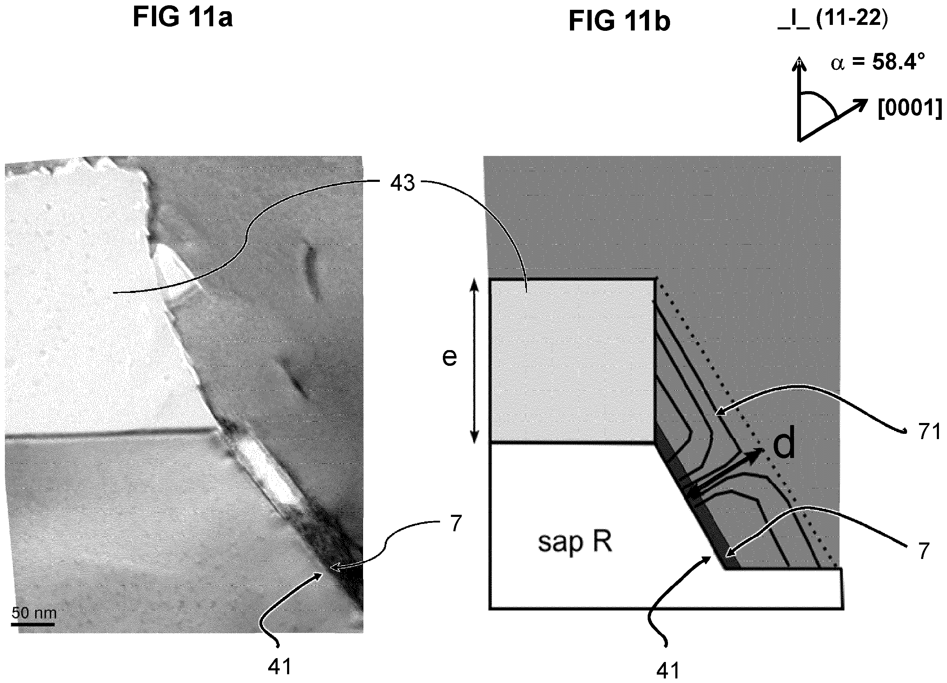

De préférence, l'épaisseur de la couche de masque 45 est au moins égale à 200 nm. Ceci permet de bloquer les défauts d'empilement BSF et une partie des dislocations présentent dans les cristaux de GaN formés dans la phase ultérieure de formation des cristaux de GaN. En particulier, toute zone de défauts parallèle à la facette C et d'épaisseur d, pourra être efficacement bloquée par un masque d'épaisseur e supérieure ou égale d/cos(a), α étant l'angle que forme la facette c avec la surface (cf. Fig11b).

### 1.2. Phase de formation de cristaux de GaN

Avantageusement, le substrat de départ 4 texturé peut comprendre une première étape 20 de nitruration comprenant un recuit du substrat 4 sous atmosphèred'ammoniac NH3 à une température supérieure à 900°C, de préférence supérieure à 1000°C, au cours de la mise en oeuvre de la phase 2 de formation de premiers cristaux 5 de GaN. Ceci permet de faciliter toute étape de dépôt ultérieure de GaN.

La phase 2 de formation des premiers cristaux 5 de GaN comprend une étape 21 de dépôt d'une couche SiNx, de préférence d'une épaisseur inférieure à dix monocouches, sur le substrat de départ 4 par exemple par exposition au silane SiH₄ et à l'ammoniac NH₃ à une température supérieure à 900°C, de préférence supérieure à 1000°C, suivie d'une étape 22 de dépôt d'une première couche tampon, par exemple de GaN.

La première couche tampon est déposée à basse température (typiquement à une température inférieure à 750°C), par exemple en mettant en oeuvre la technique de dépôt par épitaxie en phase vapeur aux organométalliques (EPVOM) ou par épitaxie en phase vapeur aux hydrures (HVPE). L'épaisseur de la (première) couche tampon est de préférence supérieure à 25 nm.

La première couche tampon est ensuite traitée thermiquement pour induire sa migration au niveau des surfaces des flancs inclinés 41 d'orientation cristalline C (0001) des gorges 40 du substrat de départ 4.

Plus précisément, une étape 23 de recuit thermique sous hydrogène à une température supérieure ou égale à 950°C est mise en oeuvre pour induire cette migration et former des premiers germes d'orientation cristalline C (0001) sur les flancs inclinés 41 d'orientation cristalline C (0001) des gorges 40 du substrat de départ 4.

Une étape 24A de croissance de premiers cristaux 5 de GaN (par exemple par EPVOM ou HVPE) est ensuite mise en oeuvre sur les premiers germes de GaN d'orientation cristalline C (0001). Cette étape 24A de croissance peut être mise en oeuvre à une température comprise entre 900°C et 1300°C, à une pression comprise entre 0,2 bar et 1 bar, soit entre 0,2×10⁵ Pa et 10⁵ Pa, et à un rapport V/III compris entre 500 et 6000.

De préférence, dans le cadre d'un réacteur EPVOM, les paramètres de croissance pour cette étape 24A peuvent être : une pression comprise entre 0.5 bar et 1 bar (soit entre 0,5×10⁵ Pa et 1×10⁵ Pa), une température comprise entre 1080°C et 1100°C, un rapport V/III compris entre 1000 et 3500. Ces paramètres varient évidemment en fonction des réacteurs et de la méthode de croissance adoptée (EPVOM ou HVPE).

La phase 2 consistant à former les premiers cristaux 5 comprend ensuite une étape de croissance orientée 24B pour favoriser une vitesse de croissance des premiers cristaux 5 selon des plans cristallographique (0001) supérieure aux vitesses de croissance des premiers cristaux 5 selon les plans perpendiculaires à (0001), tels que des plans cristallographiques (1120). Du fait de la croissance orientée des premier cristaux 5 et du fait que cette croissance se fait sur les facettes, qui sont espacées les unes des autres, des cavités triangulaires 52 se forment entre le substrat 4 et les premiers cristaux 5, entre les facettes en raison de l'absence de croissance des premiers cristaux 5 sur le substrat 4 entre les facettes.

Ainsi, au cours de l'étape 24B, les paramètres de croissance (par exemple par EPVOM ou HVPE) sont adaptés afin de favoriser la vitesse de croissance de certains plans cristallographiques par rapport à d'autres. Plus précisément, les paramètres de croissance sont adaptés pour limiter la vitesse de croissance des premiers cristaux 5 selon les plans a (1120) par rapport à la vitesse de croissance selon les autres plans, et notamment les plans C (0001) et (1122). Ceci permet de favoriser le chevauchement entre les premiers cristaux 5 de GaN adjacents.

Notamment, l'étape de croissance orientée 24B peut être réalisée à une pression comprise entre 0,03 bar et 0,5 bar (soit entre 0,03×10⁵ Pa et 0,5×10⁵ Pa), à une température comprise entre 900°C et 1300°C et à un ratio V/III compris entre 250 et 3000. De préférence, l'étape de croissance orientée 24B est réalisée à une pression comprise entre 0,1 bar et 0,5 bar (soit entre 0,1×10⁵ Pa et 0,5×10⁵ Pa), à une température comprise entre 1000°C et 1300°C et à un ratio V/III compris entre 500 et 3000.

Ce chevauchement induit le blocage des défauts cristallins se propageant à travers les premiers cristaux 5 de GaN. On obtient ainsi un matériau semi-conducteur incluant une couche de GaN semi-polaire de haute qualité.

La croissance des premiers cristaux 5 de GaN est poursuivie jusqu'à chevauchement des premiers cristaux 5 de GaN adjacents. Ce chevauchement peut être prononcé en prolongeant l'étape 24B, ce qui entraine la création de cavités allongées 53 entre les cristaux dans le plan de rencontre à l'issue du chevauchement. De préférence, le chevauchement des premiers cristaux s'étend, dans la direction de croissance, sur une distance supérieure à 1 µm.

Alors que les cavités triangulaires 52 sont au contact du substrat 4 et résultent de la croissance orientée des premiers cristaux 5 à des zones localisées aux facettes, les cavités allongées 53 résultent de l'intersection des premiers cristaux entre eux,
De manière générale, les cavités allongées 53 se situe au-dessus des cavités triangulaires 52, puisque les cavités triangulaires se trouvent à un niveau dans lequel les premiers cristaux ne se sont pas encore rencontrés, tandis que les cavités allongées 53 se situent au niveau de cette rencontre.

Ces cavités allongées assurent un blocage complet des défauts rencontrant une de ces cavités.

A l'issue de l'étape de croissance des premiers cristaux 5 de GaN, la phase 2 de formation des premiers cristaux de GaN est terminée.

Le procédé peut être poursuivi en mettant en oeuvre la phase 3 de coalescence jusqu'à l'obtention d'une couche bidimensionnelle de GaN. Pour obtenir la couche bidimensionnelle de GaN, les conditions de croissances suivantes peuvent par exemple être mises en oeuvre : une pression comprise entre 0.03 et 0,8 bars (soit 0,3×10⁴ Pa à 0,8×10⁵ Pa), une température comprise entre 1060°C et 1080°C, et un rapport V/III compris entre 1500 et 4000.

En variante, le procédé peut être poursuivi en mettant en oeuvre une phase 2bis de formation de seconds cristaux 6 de GaN sur les premiers cristaux 5 de GaN. La phase 2bis comprend les mêmes étapes que la phase 2, les conditions de croissance étant choisies similaires. Le fait de répéter une ou plusieurs fois les étapes de la phase 2 permet d'améliorer encore la qualité cristalline de la couche de GaN du matériau semi-conducteur.

Lorsque la phase 2bis de formation des seconds cristaux est mise en oeuvre, le procédé peut comprendre une étape 25 de dépôt d'une couche SiNx sur les premiers cristaux 5 de GaN, par exposition au silane et NH3, à une température supérieure à 950°C. Une étape 26 de dépôt d'une deuxième couche tampon est ensuite effectuée. Cette deuxième couche tampon peut être une couche de GaN déposée dans les mêmes conditions que la première couche tampon (i.e. basse température inférieure à 750°C par EPVOM ou HVPE).

La deuxième couche tampon est recuite thermiquement (étape 27) pour former des deuxièmes germes cristallins à la surface des premiers cristaux 5, préférentiellement sur les plans cristallographiques c (0001) et a (1120) des cristaux 5. De préférence, l'étape consistant à recuire thermiquement 27 la couche tampon est mise en oeuvre à une température supérieure à 950°C sous atmosphère comprenant de l'hydrogène pour créer des deuxièmes germes sur les faces a (1120) et c (0001) des cristaux 5.

Une étape 28A de croissance de seconds cristaux 6 de GaN à partir des deuxièmes germes est ensuite mise en oeuvre par EPVOM ou HVPE.

La phase 2bis consistant à former les seconds cristaux 6 comprend une étape de croissance orientée 28B pour favoriser une vitesse de croissance des seconds cristaux 6 selon des plans cristallographique (0001) supérieure aux vitesses de croissance des seconds cristaux 6 selon les plans perpendiculaires à (0001), tels que des plans cristallographiques (1120).

Ainsi, l'étape de croissance orientée 28B est mise en oeuvre à la suite de l'étape 28A, dans laquelle les conditions de croissance des seconds cristaux 6 de GaN sont adaptées de sorte à favoriser leur croissance selon les plans c (0001) et (112̅2) et ralentir leur croissance selon les plans a (1120). Ceci permet de favoriser le chevauchement entre les deuxièmes cristaux 6 de GaN adjacents.

Notamment, l'étape de croissance orientée 28B peut être réalisée à une pression comprise entre 0,03 bar et 0,5 bar (soit entre 0,03×10⁵ Pa et 0,5×10⁵ Pa), à une température comprise entre 900°C et 1300°C et à un ratio V/III compris entre 250 et 3000. De préférence, l'étape de croissance orientée 28B est réalisée à une pression comprise entre 0,1 bar et 0,5 bar (soit entre 0,1×10⁵ Pa et 0,5×10⁵ Pa), à une température comprise entre 1000°C et 1300°C et à un ratio V/III compris entre 500 et 3000.

Une fois le chevauchement des cristaux 6 obtenu, ce chevauchement peut être à nouveau prononcé afin de former à nouveau des cavités allongées 63 permettant un blocage complet des défauts rencontrant une de ces cavités.

Le procédé comprend une phase 3 de coalescence des seconds cristaux 6 de GaN jusqu'à obtenir un couche bidimensionnelle de GaN, de sorte à obtenir un matériau semi-conducteur incluant une couche de GaN semi-polaire dont la surface est sensiblement plane. Pour obtenir la couche bidimensionnelle de GaN, les conditions de croissances suivantes peuvent par exemple être mises en oeuvre : une pression comprise entre 0,03 et 0,8 bars (soit 0,3×10⁴ Pa à 0,8×10⁵ Pa), une température comprise entre 1060°C et 1080°C, et un rapport V/III compris entre 1500 et 4000 .

A l'issu de la phase 3, le matériau semi-conducteur comporte :
- un substrat de départ 4 - par exemple de saphir r (11̅02) - incluant des gorges 40,
- une couche de GaN planaire d'orientation cristallographique semi-polaire-, par exemple d'orientation (1122),- incluant des cristaux 5, 6 de GaN, les cristaux 5, 6 adjacents se chevauchant.

Les seuls défauts observés à la surface de la couche de GaN de ce matériau semi-conducteur sont des joints de coalescence et des dislocations dont la concentration est inférieure à 1×10⁸ cm⁻².

Avantageusement, le substrat de départ peut être séparé de la couche de GaN par toute technique de séparation connue de l'homme du métier de sorte à obtenir un matériau semi-conducteur incluant une couche de GaN semi-polaire autosupportée.

On va maintenant décrire différents exemples de mise en oeuvre du procédé décrit ci-dessus.

### 2. Exemples

### 2.1. Exemple 1

Dans l'exemple suivant, le substrat de départ sur lequel est épitaxiée la couche de GaN est un disque de saphir de 50,8 mm de diamètre, d'orientation cristallographique r (11̅02). Une première étape de dépôt d'un masque de diélectrique SiO₂ ou Si₃N₄ de 200 nm d'épaisseur est effectuée par des procédés de photolithographie. Le masque est déposé sous forme de bandes parallèles à la direction [11'20] du saphir de largeur 7 µm et d'ouverture 3 µm.

Ce substrat peut éventuellement être recuit à une température supérieure à 1000°C en présence de gaz tel que H2, NH3, N2 par exemple.

La surface du substrat est ensuite gravée sous forme de créneaux parallèles de période 10 microns. Cette texturation est obtenue par gravure chimique dans un bain d'acide (H₃PO₄/ H₂SO₄ en proportion volumique 1 :3) porté à 260°C. Comme le montre la figure 2a, chaque flanc 41, 42 de part et d'autre des créneaux 40 est incliné et correspond aux plans cristallographiques C (0001) et {11̅01} du saphir. Le sommet des créneaux 43 est recouvert d'une couche 43 de diélectrique SiO₂ ou Si₃N₄ de 200 nm d'épaisseur, la partie résiduelle du masque surplombant la partie abrasée du saphir ayant été enlevée par nettoyage dans des bains d'acétone, isopropanol ou H₂0 exposés aux ultrasons.

La croissance de GaN est réalisée dans un réacteur d'épitaxie en phase vapeur par pyrolyse de composés organométalliques (EPVOM). L'élément Ga est apporté par le tri-méthylgallium (TMG) et l'élément N par l'ammoniac (NH₃). Ces deux gaz précurseurs sont décomposés thermiquement à la surface du saphir pour former des liaisons Ga-N.

La première étape consiste à nitrurer le substrat à 1080°C par exposition pendant 7 min à un mélange gazeux (NH3, N2, H2), puis à déposer une couche de SiNx par exposition au silane SiH4 et NH3.

La deuxième étape consiste à déposer une couche tampon de GaN de 27 nm à basse température (580°C).

Puis la température est montée à 1100°C. Durant cette phase, la couche tampon se redistribue par diffusion en phase solide vers les flancs 41 d'orientation cristallographique C (0001) du saphir 4 pour former des germes.

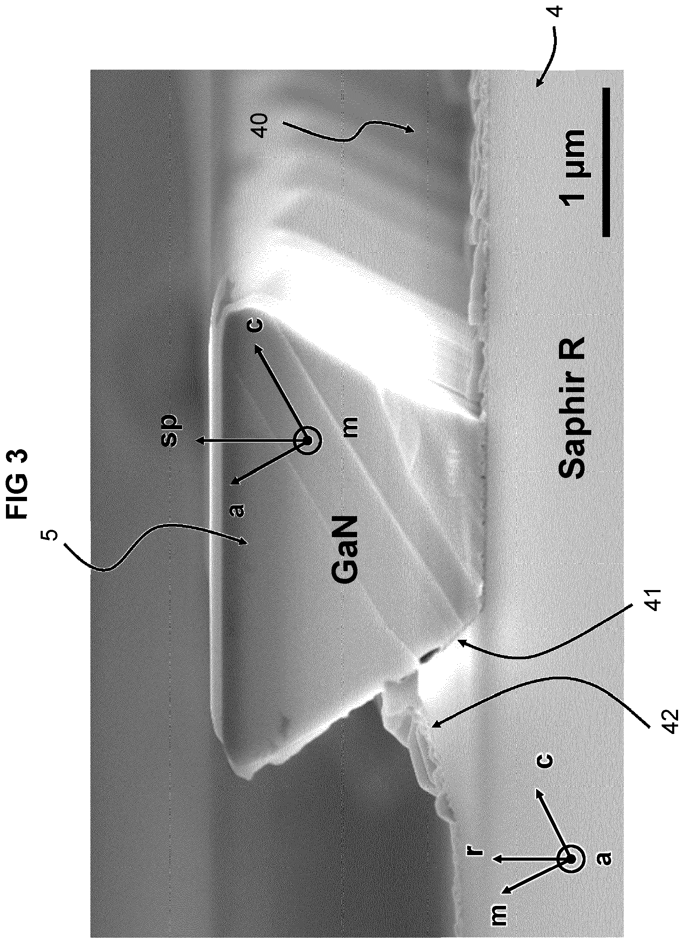

On reprend ensuite la croissance de GaN à partir des germes localisés sur les flancs 41 d'orientation cristallographique C (0001). La figure 3 illustre la morphologie des cristaux 5 de GaN obtenus après dix minutes de croissance, sous une pression de 0,8 bars, soit 0,8×10⁵ Pa à une température de 1080°C et avec un rapport V/III de 3500.

Comme illustré sur la figure 3, l'orientation cristallographique C (0001) des cristaux de GaN 5 est parallèle à l'orientation cristallographique C (0001) du saphir 4. Cette relation d'épitaxie est similaire à celle de la croissance de GaN polaire (plan C) sur saphir polaire (plan C). Comme les flancs 41 d'orientation cristallographique C (0001) du saphir 4 sont inclinés, l'axe C (0001) du GaN est également incliné par rapport à une normale « sp » à la surface du saphir 4. Cette inclinaison présente un angle d'environ 58°, ce qui indique une orientation (112̅2) semi-polaire des cristaux de GaN. Cette orientation est confirmée par diffraction aux rayons X.

La croissance des cristaux 5 de GaN est ensuite poursuivie, sous une pression de 0,1 bar (soit 0,1×10⁵ Pa), à une température de 1100°C et avec un rapport V/III de 500, jusqu'à obtenir un chevauchement de ceux-ci. Au moyen des conditions de croissance, la forme triangulaire des cristaux 5 de GaN illustrés à la figure 3 peut être modifiée, afin de favoriser la vitesse de croissance du GaN selon certains plans cristallographiques par rapport à d'autres. Il est notamment possible de modifier la pression et le flux d'ammoniac dans le réacteur.

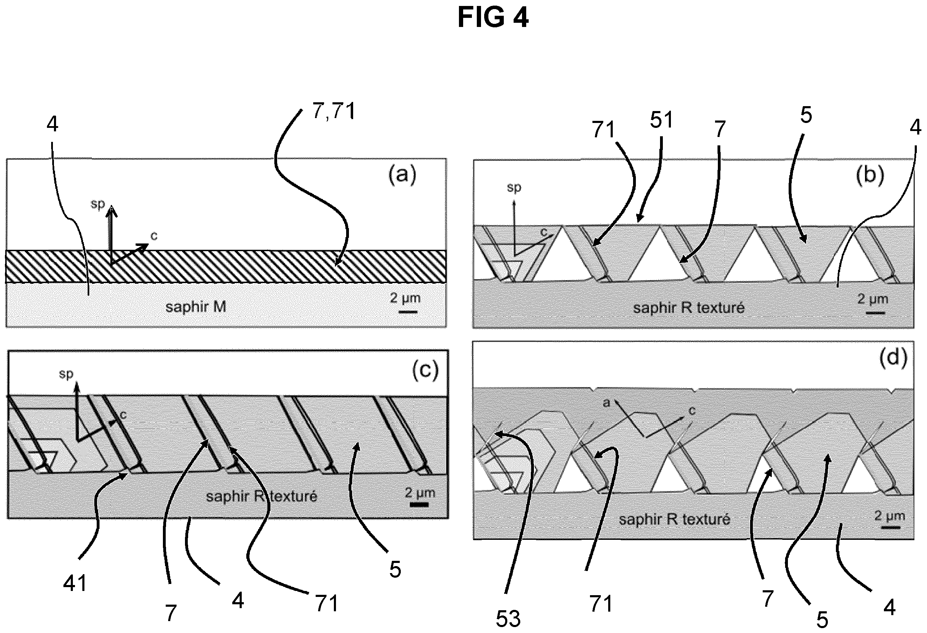

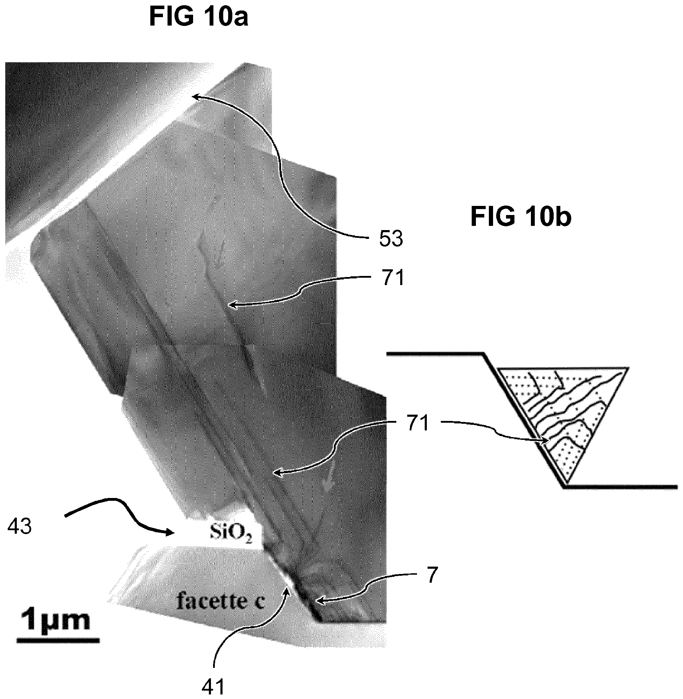

Pour mieux comprendre les avantages du procédé selon l'invention, les figures 4a à 4d illustrent différents exemples de croissance de GaN sur un saphir 4 texturé (figures 4b-4d) ou non texturé (figure 4a). Les lignes 7 et 71 illustrées sur les figures 4a-4d correspondent respectivement à des fautes d'empilement (ci-après dénommés BSF) et aux dislocations. Les BSF 7 sont des défauts planaires dans le plan de base (0001) de la maille hexagonale, et les dislocations 71 sont des défauts linéaires générés à partir de la facette C et se propageant à angle droit, dans le plan de base (0001), comme le montre l'image TEM de la figure 10a.

La figure 4a représente le cas d'une épitaxie planaire (i.e. non localisée) de GaN semi-polaire (112̅2) sur un saphir 4 non texturé d'orientation cristallographique m (11̅00). Comme on peut l'observer sur la figure 4a, les BSF 7 représentés par des lignes noires se forment à l'interface entre le substrat 4 de saphir et la couche de GaN, et sont répartis sur toute la surface du substrat de saphir. La densité surfacique des BSF 7 est très élevée. Cette densité est typiquement de l'ordre de 10⁵ cm⁻¹. Les dislocations associées aux BSF ont une densité de l'ordre de 10¹⁰ cm⁻².

Les figures 4b, 4c, 4d illustrent la croissance localisée des cristaux 5 de GaN semi-polaires à partir des flancs 41 d'orientation cristallographique C (0001) d'un saphir 4 texturé. Les BSF 7 sont cette fois localisées à l'interface saphir/GaN au niveau des flancs 41 d'orientation cristallographique C (0001) du saphir 4, ce qui diminue considérablement leur densité. Du fait que la croissance a lieu au niveau des facettes C, certaines dislocations 71 se propagent dans une direction normale à la facette puis se courbent à angle droit dans le plan de base (0001) (voir TEM figure 10a)).

Alors que dans les exemples illustrés aux figures 4b et 4c, les BSF 7 et les dislocations 71 se propagent jusqu'à la surface 51 de la couche de GaN, dans l'exemple illustré à la figure 4d, les BSF 7 et les dislocations 71 sont bloqués au niveau des jonctions entre cristaux 5 adjacents du fait de leur chevauchement. La présence des cavités allongées 53 dans la région de coalescence permet un blocage très efficace des dislocations.

Ainsi, en choisissant des conditions de croissance où la vitesse de croissance des plans a (1120) est plus faible que la vitesse de croissance des plans C (0001), on favorise le chevauchement des cristaux 5 adjacents et la formation de cavités 53, permettant ainsi de bloquer les BSF 7 et les dislocations 71. En mettant en oeuvre une croissance des cristaux 5 de GaN telle qu'illustrée à la figure 4d, on peut ainsi filtrer les BSF 7 et la plupart des dislocations 71 de sorte à améliorer la qualité de la couche de GaN.

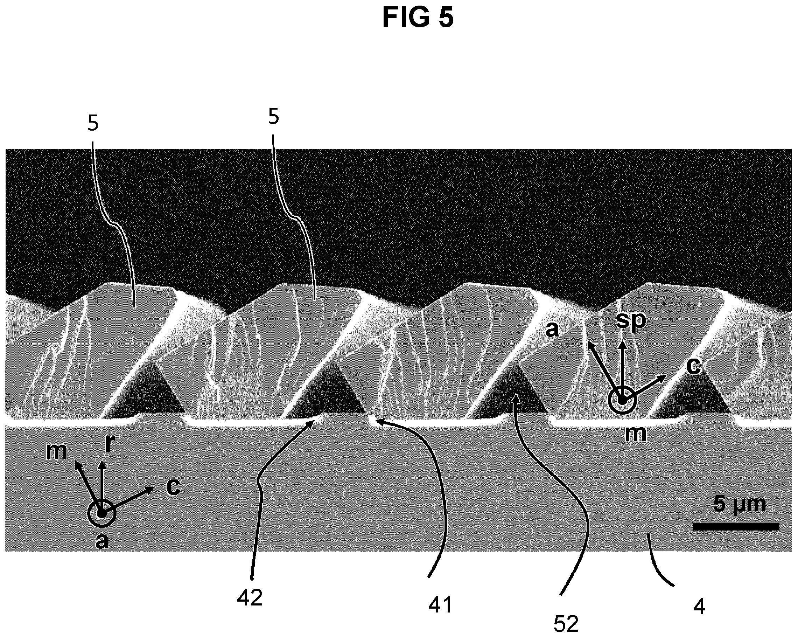

L'accroissement des cristaux 5 selon l'exemple illustré à la figure 4d a été produit expérimentalement pour des conditions de basse pression et de faible flux d'ammoniac. La figure 5 est une image par microscopie électronique à balayage en section transversale des cristaux 5 de GaN obtenus après 1h30 de croissance sous une pression de 0,1 bars, soit 0,1×10⁵ Pa, une température de 1100°C et un rapport V/III de 500. Comme on peut le constater sur la figure 5, le chevauchement des cristaux 5 adjacents favorise le blocage des BSF 7 et des dislocations 71.

Après le chevauchement des cristaux 5 de GaN, la croissance est poursuivie pendant environ 2 heures, sous une pression de 0,1 bar (soit 0,1×10⁵ Pa), une température de 1060°C et un rapport V/III de 3000, de sorte à obtenir une couche de GaN bidimensionnelle ayant une surface lisse.

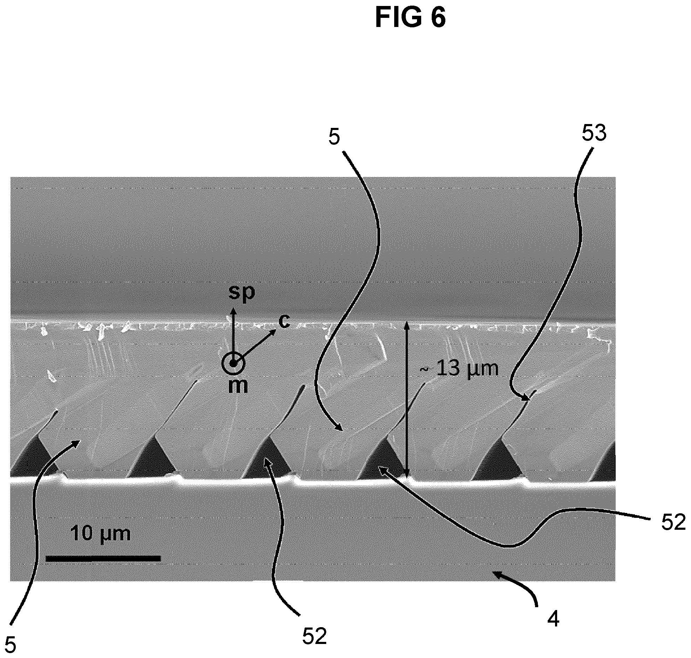

La figure 6 illustre la morphologie de la couche GaN coalescée. On remarque des cavités triangulaires 52 à l'interface saphir/GaN, périodiquement espacées tous les 10 microns, qui proviennent du mode de croissance localisé décrit précédemment. On remarque également la présence de cavités allongées 53 à l'intersection entre deux cristaux adjacents. Ces cavités sont propices au blocage des défauts cristallins, comme le montre l'image TEM de la figure 10a).

La qualité de cette couche de GaN a été évaluée par photoluminescence (PL) et cathodoluminescence (CL).

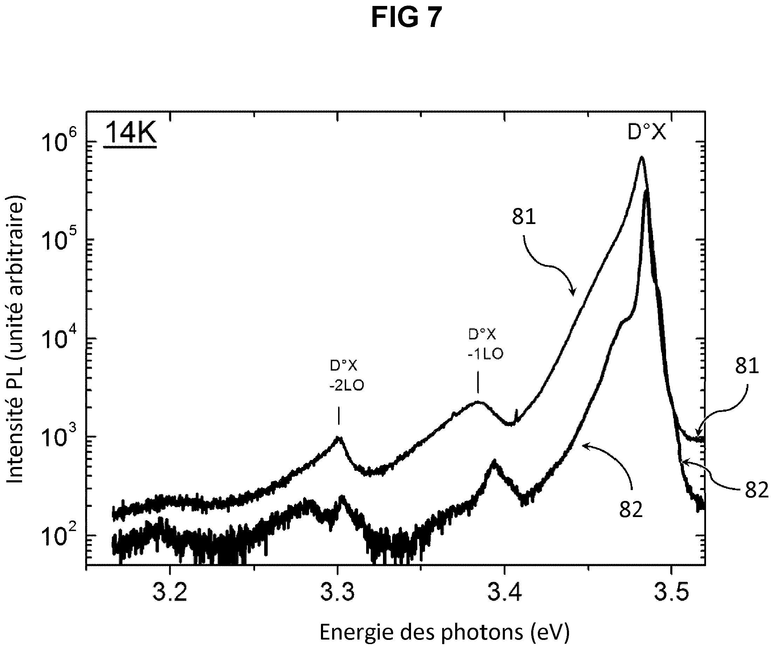

La figure 7 illustre des premier et deuxième spectres 81, 82 de photoluminescence PL. Le premier spectre 81 correspond au spectre de PL à 16K du GaN semi-polaire obtenu en mettant en oeuvre le procédé selon l'invention. Le deuxième spectre 82 correspond au spectre de PL du GaN polaire servant de référence.

Comme on peut le constater, les spectres 81, 82 sont dominés par une émission intense vers 3,48 eV correspondant aux transmissions excitoniques du GaN. On remarque tout d'abord que les intensités PL vers 3,48 eV sont équivalentes sur les premier et deuxième spectres. Ceci est une première indication que les densités de défauts non radiatifs dans le GaN semi-polaire et le GaN polaire sont du même ordre de grandeur. Les spectres ne présentent aucune émission vers 3,43 eV, caractéristique des transitions liées au BSF.

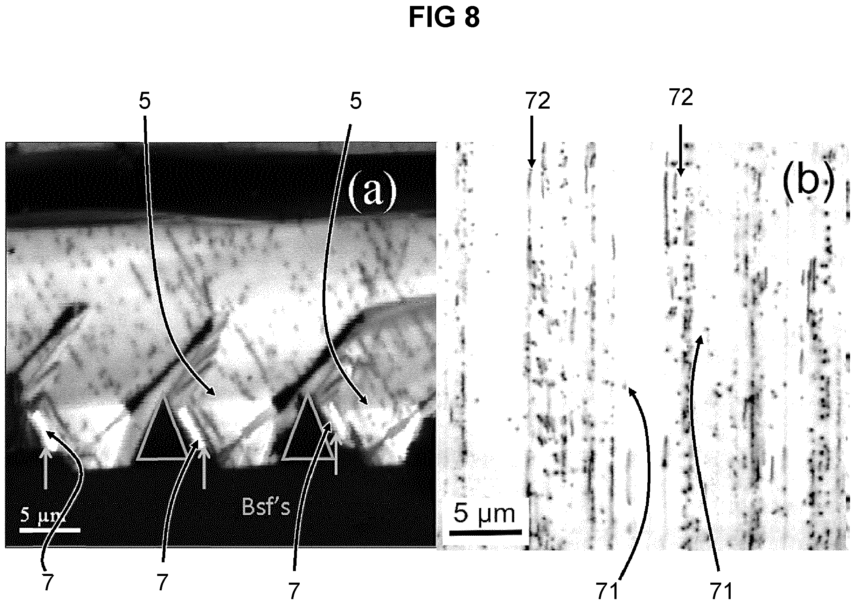

Les figures 8a et 8b sont des images de cathodoluminescence (CL) panchromatiques à 77K de la répartition de la luminescence sur la tranche et à la surface du GaN semi-polaire obtenu en mettant en oeuvre le procédé selon l'invention.

Les zones sombres correspondent à une absence de luminescence associée à la présence de défauts non radiatifs. Ces images donnent donc une information directe sur la répartition des défauts. Le blocage des BSF est mis en évidence sur la figure 8a. En effet, ces défauts émettent une luminescence vers 3,43 eV à la température de mesure (77K). Les BSF 7 d'un cristal sont bloquées à l'aplomb d'un cristal adjacent. La figure 8b illustre des joints de coalescence 72 induits par l'épitaxie localisée régulièrement espacé d'une distance de 10 microns. On observe également des points non radiatifs correspondants à des dislocations 71 émergeant à la surface et associés à des dislocations traversantes. Un comptage de ces dislocations 71 entre deux joints de coalescence 72 fait apparaître une densité comprise entre 4.9×10⁷cm⁻² et 5.7×10⁷cm⁻². Cette densité est d'un ordre de grandeur inférieure à celle des couches de GaN polaires épitaxiées sur un saphir plan C.

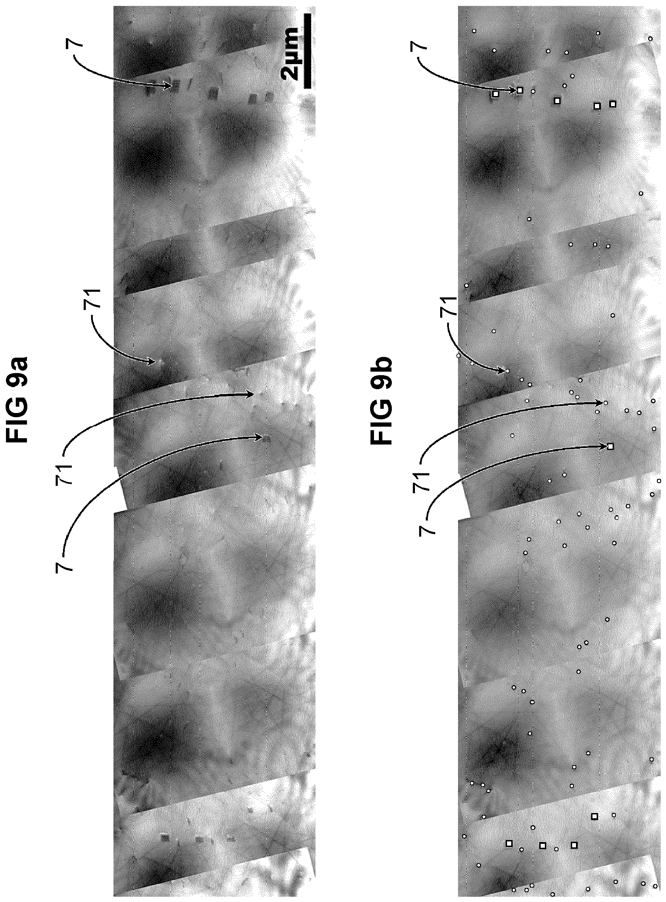

L'image TEM des figures 9a et 9b montre la répartition des défauts émergeant à la surface d'une couche coalescée de GaN semi-polaire. Les figures 9a et 9b représentent la même image, avec cependant pour la figure 9b la mise en évidence par des repères visuels des défauts visibles sur la figure 9a, avec des carrés et des cercles. Les cercles correspondent à des dislocations traversantes 71 et les carrés correspondent aux BSF 7. Un comptage de ces défauts fait apparaître une densité de dislocations de 6.8 × 10⁷ / cm² et une densité de BSFs de 69 / cm, cette dernière densité étant obtenue en additionnant la longueur des BSFs et en divisant cette quantité par la surface de comptage.

Le schéma de la figure 10b montre le développement d'un germe de GaN en cours de croissance à partir des facettes C 41 du saphir 4. Les traits noirs correspondent aux dislocations traversantes 71 et les lignes pointillées représentent le cristal dans les états intermédiaires de la croissance. Lorsqu'une dislocation 71 traversante rencontre une facette inclinée, elle se courbe vers la nouvelle surface libre, et finit par se propager à angle droit, dans le plan de base (0001). Ce processus de courbure est démontré par l'image TEM de la figure 10a. On observe bien un réseau de lignes de dislocations se propageant verticalement depuis l'interface, puis se courbant à 90° dans la direction a [112̅0]. Ces dislocations 71 sont arrêtées au niveau du vide 53 créé à l'intersection des deux cristaux adjacents.

D'autre part, les BSF 7 confinées dans le plan de base (0001) (zone noire d'épaisseur - 30 nm), sont arrêtées par le masque SiO₂

La figure 11a montre une image TEM de la région proche de la facette C 41 du saphir. On remarque que le masque 43, d'épaisseur - 300 nm, joue un rôle très efficace dans le blocage des BSFs 7.

La figure 11b montre qu'en augmentant l'épaisseur du masque, il est possible de bloquer une plus grande quantité de défauts cristallins, incluant des dislocations courbées 71. Ainsi, une zone de défauts d'épaisseur d pourra être potentiellement bloquée par un masque présentant une épaisseur e d'au moins environ d/cos(α), avec ∝=58,4°, soit environ 2d, dans le cas du GaN (1122).

La rugosité de surface (RMS) mesurée par AFM est de 4 nm pour des surfaces testées de 10x10 µm². Cette valeur est acceptable pour réaliser des composants optoélectroniques sans avoir à effectuer un polissage préalable. On observe une ondulation de la surface dans la direction [11̅00], parallèle aux joints de coalescence. Cette ondulation peut s'éliminer par polissage mécanochimique pour atteindre une rugosité inférieure au nm, si nécessaire, pour une exploitation industrielle.

### 2.2. Exemple 2

L'exemple précédent montre que l'épitaxie localisée de GaN à partir des facettes c du saphir r (11̅02) texturé permet d'obtenir du GaN semi-polaire d'orientation (1122) à faible densité de défauts.

Pour améliorer encore la qualité cristalline du GaN semi-polaire, le principe de blocage des défauts cristallins par chevauchement de cristaux est répété deux fois.

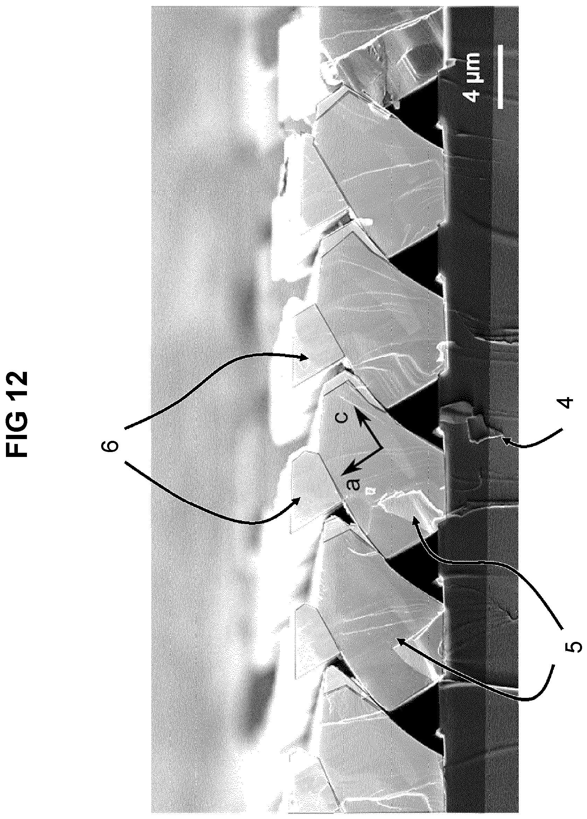

La figure 12 illustre la croissance de seconds cristaux 6 au-dessus de premiers cristaux 5, par le procédé décrit ci-dessus. Les seconds cristaux 6 sont obtenus après avoir :
- déposé une monocouche de SiNx sur les premiers cristaux 5,
- déposé une deuxième couche tampon de GaN (30 nm) à 580°C,
- traité thermiquement la deuxième couche tampon,
- effectué une croissance des seconds cristaux 6 de GaN à haute température (1100°C) pendant 25 minutes à 0,8 bar, sous un flux de NH₃ de 3,5 litres standard par minute, noté slm de l'anglais «standard litre per minute », avec un rapport V/III = 3500.

On remarque que la nucléation se fait sélectivement sur les facettes a et c des premiers cristaux 5.

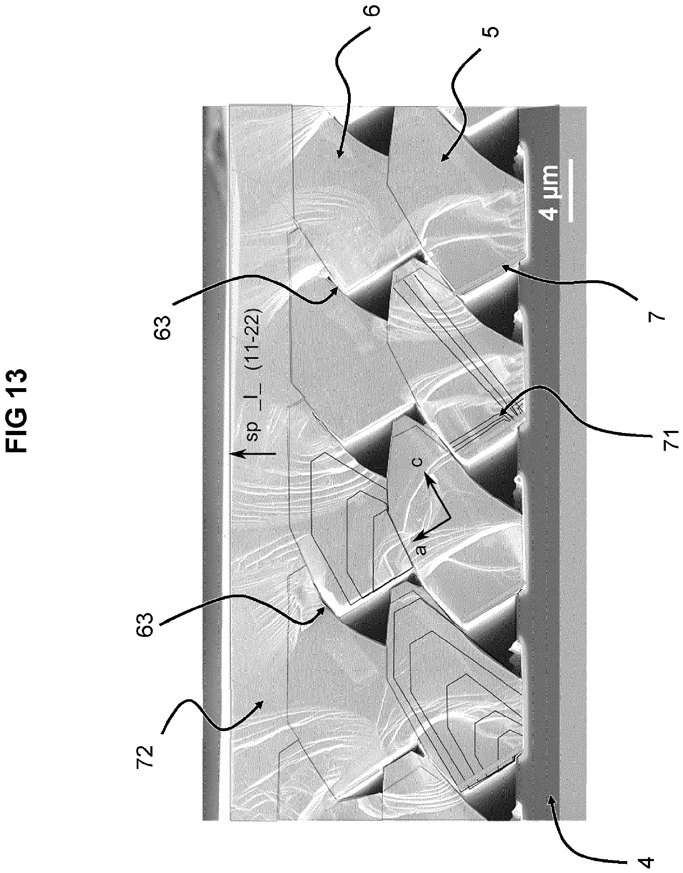

A partir de ces germes, on diminue en même temps le flux d'ammoniac à 0,5 litre standard par minute et la pression dans le réacteur à 0,1 bar, et la croissance est poursuivie pendant 2 heures. Ces conditions de croissance favorisent l'expansion latérale des cristaux vers la direction c (croissance asymétrique). La morphologie de la structure finale coalescée est représentée sur la figure 13. Notons que les conditions de croissance au cours de la 1^{ere} étape (premiers cristaux) et de la 2^{eme} étape (deuxièmes cristaux) sont les mêmes.

Cette technique de croissance de premiers et seconds cristaux 5, 6 a pour objectif de filtrer davantage de défauts. Au cours de la phase de croissance des premiers cristaux, les fautes d'empilement et les dislocations courbées qui sont générées à l'interface entre la facette c du saphir et la couche de nucléation d'un premier cristal sont bien arrêtées par le vide 53 laissé par la rencontre des plans cristallographiques des cristaux adjacents.

En revanche, les dislocations traversantes dans la direction normale à la facette c sont libres de se propager en surface, de même que les dislocations générées aux joints de coalescence. Ces défauts sont potentiellement bloqués par le deuxième plan de cavités triangulaires qui se forme au cours de la phase de croissance des seconds cristaux.

Au cours de cette phase de croissance des seconds cristaux, des BSF 7 peuvent être créés à l'interface avec les facettes a du cristal sous-jacent et la couche tampon. Ces défauts sont à nouveau bloqués par les cavités allongées 63 qui se forment avec le cristal voisin grâce à la croissance asymétrique.

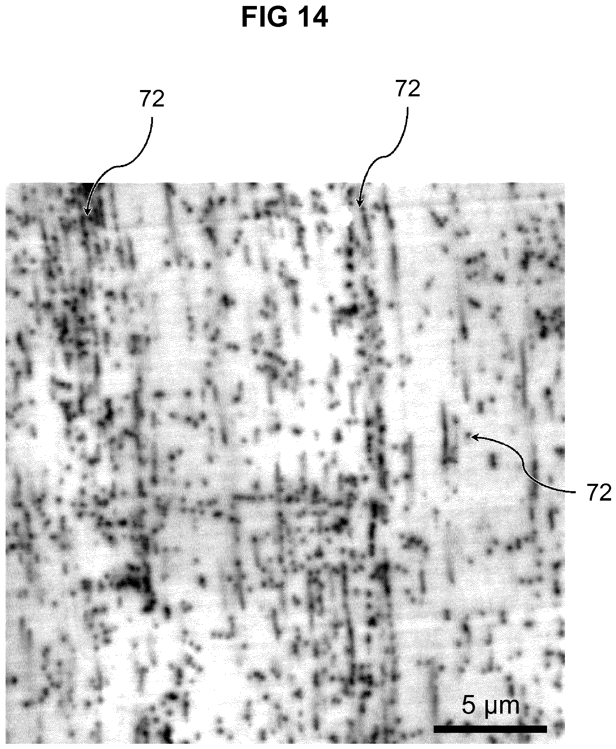

Après la phase 3 de coalescence des cristaux 6, la surface a été analysée par cathodoluminescence panchromatique (CL). La figure 14 montre la cathodoluminescence à 77K de la surface.

A cette température, les BSF émettent une luminescence intense vers 3,41 eV. On n'observe pas de luminescence associée aux BSF à la surface, ce qui prouve que le filtrage de ces défauts a été efficace. Les défauts présents sont exclusivement des dislocations traversantes 71. Les joints de coalescence 72 qui apparaissaient sous l'aspect de lignes noires contrastées dans l'exemple 1 (FIG 8b), sont ici difficilement visibles.

Le procédé de croissance de premiers et seconds cristaux aboutit à une répartition plus homogène des défauts en surface. La densité de points noirs est ici de 1.7×10⁸ cm⁻².

Si ce type de substrat est utilisé pour l'épitaxie de composants optoélectroniques, une répartition inhomogène des défauts en surface peut induire des instabilités, tels que des courants de fuite, des points chauds, etc.

En conséquence, le procédé en deux étapes de croissance de cristaux (i.e. premiers et seconds cristaux) peut apporter une amélioration dans ce domaine.

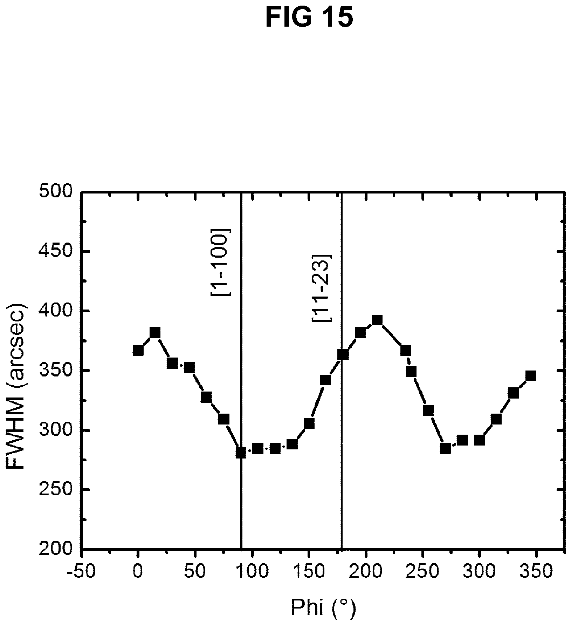

La figure 15 montre la mesure de la largeur à mi-hauteur (FWHM, de l'anglais « Full width at half maximum ») de l'intensité diffractée par les plans (112̅2) lorsqu'on incline l'échantillon de part et d'autre d'un axe perpendiculaire aux plans (1122), dénommée « rocking curve » dans la terminologie anglo-saxonne. Cette mesure est effectuée pour chaque angle azimutal, c'est-à-dire l'angle que fait le plan d'incidence des rayons X avec la direction cristallographique dans le plan de la couche.

A phi = 90°, le plan d'incidence des rayons X est parallèle à la direction [11̅00] (direction le long des bandes). Les fluctuations de FWHM témoignent d'une anisotropie cristalline dans le plan de la couche. Les valeurs de FWHM sont inférieures à 400 secondes d'arc.

Ainsi, la couche de nitrure d'élément III se caractérise par une courbe d'intensité de diffraction de rayons X des plans cristallographiques {11-22} en fonction de l'angle d'incidence du faisceau de rayons X sur ces plans présentant une largeur à mi-hauteur inférieure à 400 secondes d'arc.

A noter que ces substrats semi-polaires peuvent être également utilisés pour réaliser des substrats autosupportés, c'est-à-dire une couche semi-polaire séparée du substrat hôte 4. La séparation peut avoir lieu par exemple au cours ou à l'issue de la phase 3 de coalescence des cristaux jusqu'à formation d'une couche bidimensionnelle de nitrures d'éléments III, par exemple par épaississement de la couche coalescée supérieure par la technique HVPE, qui permet de fortes vitesses de croissance.

Il est à noter que dans la mesure où la couche de nitrure d'élément III n'est relié au substrat 4 que par l'intermédiaire des facettes, de dimension réduite, l'adhérence au substrat 4 est faible, et les contraintes mécaniques au cours de l'épaississement et/ou du refroidissement peuvent suffire à induire la séparation.

Dans ce cas, on peut escompter une diminution notable des défauts. En effet, l'épaississement apporte une réduction significative du nombre de dislocations. Au cours de la croissance, certaines dislocations traversantes se courbent et s'annihilent entre elles en formant des boucles.

Dans le but d'obtenir du GaN semi-polaire autosupporté, les couches obtenues par le procédé en deux étapes peuvent s'avérer plus appropriées. En effet, la présence de cavités triangulaires sur deux étages devrait induire une fragilisation supplémentaire au cours d'un épaississement HVPE, bénéfique pour un décollement de GaN du substrat hôte (saphir).

## Revendications

1. Procédé de fabrication d'un matériau semi-conducteur incluant une couche de nitrure d'élément III semi-polaire à partir d'un substrat de départ (4) incluant une pluralité de gorges (40) espacées périodiquement d'une distance L2, chaque gorge (40) incluant un premier flanc (41) incliné d'orientation cristallographique C (0001) et un deuxième flanc (42) incliné d'orientation cristallographique différente, un premier flanc incliné d'une gorge et un second flanc incliné d'une gorge adjacente formant un créneau (43), le sommet du créneau étant recouvert d'un masque, le procédé comprenant les phases consistant à :
- Former (2) des premiers cristaux (5) de nitrure d'élément III sur les premiers flancs (41) inclinés des gorges (40), les paramètres de croissance des cristaux (5) de nitrure d'élément III étant adaptés pour favoriser une croissance latérale desdits cristaux,
o la croissance induisant d'abord des cavités triangulaires (52) formées entre le substrat et deux cristaux de nitrure d'élément III adjacents, une cavité triangulaire comprenant une base, deux murs et un vertex, la base correspondant au substrat, un mur correspondant à un premier cristal de nitrure d'élément III, l'autre mur correspondant audit premier cristal de nitrure d'élément III adjacent, et le vertex correspondant au début de l'intersection entre les deux cristaux adjacents, la présence du masque évitant une croissance parasite sur la surface couverte par le masque,
o puis induisant un chevauchement entre les cristaux (5) de nitrure d'élément III adjacents de manière à former des cavités allongées (53) débutant à partir du vertex et disposées au-dessus des cavités triangulaires au droit des zones de chevauchement entre les premiers cristaux (5) dans le plan de rencontre entre les premiers cristaux (5), à l'intersection entre deux premiers cristaux adjacents se chevauchant ;
- Former (3) une couche bidimensionnelle de nitrure d'élément III sur les cristaux (5, 6) de nitrure d'élément III préalablement formés.

2. Procédé selon la revendication 1, lequel comprend en outre une phase (2bis) consistant à former des seconds cristaux (6) sur les premiers cristaux (5), les paramètres de croissance des seconds cristaux (6) de nitrure d'élément III étant adaptés pour favoriser une croissance latérale desdits seconds cristaux de sorte à induire un chevauchement entre les seconds cristaux (6) de nitrure d'élément III adjacents et à former des cavités (63) aux droits des zones de chevauchement des seconds cristaux (6).

3. Procédé selon l'une quelconque des revendications 1 à 2, lequel comprend en outre une phase (1) consistant à texturer le substrat de départ (4), ladite phase (1) incluant une étape consistant à former la pluralité de gorges (40) dans le substrat de départ (4).

4. Procédé selon la revendication 3, dans lequel l'étape consistant à former la pluralité de gorges comprend les sous-étapes de :
- dépôt d'un masque (45) diélectrique ou métallique d'épaisseur comprise entre 200 nm et 100 micromètres de période L2 incluant des ouvertures (44),
- Recuit du substrat de départ (4) comportant le masque à une température supérieure à 900°C sous atmosphère comprenant de l'ammoniac NH3 et/ou un mélange dihydrogène-diazote H2/N2, préalablement à la gravure chimique dans un bain d'acide,
- gravure du substrat de départ (4) à travers les ouvertures (44) du masque (45), par introduction du substrat de départ (4) dans un bain d'acide pour former les gorges (40).

5. Procédé selon la revendication 4, dans lequel les paramètres de l'étape de gravure du substrat (4) sont adaptés pour former des gorges (40) de largeur supérieure aux ouvertures initiales (44), grâce à l'abrasion latérale sous le masque pour former des zones abrasées, lesdites gorges incluant chacune un premier flanc (41) incliné d'orientation cristallographique C (0001) et un deuxième flanc (42) incliné d'orientation cristallographique différente d'un plan C (0001), par exemple un plan (11̅01) dans le cas du saphir r.

6. Procédé selon la revendication 5, dans lequel les parties du masque surplombant les zones abrasées sont enlevées par une procédure de nettoyage comprenant un traitement dans un bain aux ultrasons, de telle sorte qu'à l'issue de la procédure de nettoyage, le substrat (4) comporte en surface des bandes de masque (43) aux flancs sensiblement verticaux et des gorges (40).

7. Procédé selon l'une quelconque des revendications 1 à 6, dans lequel la phase (2) consistant à former des premiers cristaux (5) comprend les étapes consistant à :
- déposer (22) une couche tampon de nitrures d'éléments III par épitaxie en phase vapeur aux organométalliques EVPOM d'une couche de nitrure d'élément III à une température inférieure à 750°C;
- recuire thermiquement (23) la couche tampon à une température supérieure à 950°C sous atmosphère comprenant de l'hydrogène de sorte à réaliser la migration en phase solide de la couche tampon vers le premier flanc incliné (41) d'orientation C de chaque gorge et ainsi former des premiers germes d'orientation cristallographique C (0001) sur les premiers flancs (41) des gorges (40).

8. Procédé selon la revendication 7, dans lequel la phase (2) consistant à former des premiers cristaux comprend une étape (24A) consistant à faire croître les premiers cristaux (5) sur les premiers germes, et dans lequel l'étape (24A) consistant à faire croître les premiers cristaux est mise en oeuvre à une température comprise entre 900°C et 1300°C, à une pression comprise entre 0,2×10⁵ Pa et 1×10⁵ Pa.

9. Procédé selon la revendication 8, dans lequel la phase (2) consistant à former les premiers cristaux comprend une étape de croissance orientée (24B) pour favoriser une vitesse de croissance des premiers cristaux selon des plans cristallographique (0001) supérieure aux vitesses de croissance des premiers cristaux (5) selon les plans perpendiculaires à (0001), tels que des plans cristallographiques (1120).

10. Procédé selon la revendication 2, dans lequel la phase (2bis) consistant à former des seconds cristaux (6) de nitrure d'élément III comprend les étapes consistant à :
- Déposer une deuxième couche de SiNx (25) sur les premiers cristaux préexistants (5), par exposition au silane et NH3, à une température supérieure à 950°C,
- déposer (26) à une température inférieure à 750°C une deuxième couche tampon de nitrures d'éléments III sur la deuxième couche de SiNx,
- recuire thermiquement (27) la deuxième couche tampon à une température supérieure à 950°C sous atmosphère comprenant de l'hydrogène de sorte à réaliser la migration en phase solide de la couche tampon vers les faces a (1120) et c (0001) des cristaux (5), et ainsi former des deuxièmes germes sur les faces a (1120) et c (0001) des premiers cristaux (5).

11. Procédé selon la revendication 10, dans lequel la phase (2bis) consistant à former des seconds cristaux (6) comprend une étape (28A) consistant à faire croître les seconds cristaux (6) sur les deuxièmes germes, mise en oeuvre à une température comprise entre 900°C et 1300°C, une pression comprise entre 0,2×10⁵ Pa et 1×10⁵ Pa.

12. Procédé selon la revendication 11 dans lequel la phase (2bis) consistant à former les seconds cristaux (6) comprend une étape de croissance orientée (28B) pour favoriser une vitesse de croissance des seconds cristaux (6) selon des plans cristallographique (0001) supérieure aux vitesses de croissance des seconds cristaux (6) selon les plans perpendiculaires à (0001), tels que des plans cristallographiques (1120).

13. Matériau semi-conducteur incluant une couche de nitrure d'élément III semi-polaire épitaxiée sur un substrat exogène, le matériau semi-conducteur comportant une couche de nitrure d'élément III semi-polaire incluant des cristaux (5, 6) de nitrure d'élément III coalescés, les cristaux (5, 6) de nitrure d'élément III adjacents se chevauchant, ledit matériau semi-conducteur comprenant:
des cavités triangulaires formées entre le substrat et deux cristaux de nitrure d'élément III adjacents, une cavité triangulaire comprenant une base, deux murs et un vertex, la base correspondant au substrat, un mur correspondant à un premier cristal de nitrure d'élément III, l'autre mur correspondant audit premier cristal de nitrure d'élément III adjacent, et le vertex correspondant au début de l'intersection entre les deux cristaux adjacents,
et une couche bidimensionnelle de nitrure d'élément III sur lesdits cristaux, le matériau étant **caractérisée en ce qu'**il comprend des cavités allongées (53, 63) débutant à partir du vertex et disposées au-dessus des cavités triangulaires dans le plan de rencontre entre les cristaux (5), à l'intersection entre deux cristaux adjacents, et dans lequel chaque cavité allongée (53, 63) s'étend aux droits des zones de chevauchement entre les cristaux .

14. Matériau semi-conducteur selon la revendication 13, dans lequel chaque cavité allongée (53, 63) s'étend dans un plan qui surplombe au moins le plan défini par la facette cristallographique (0001) du substrat.

15. Matériau semi-conducteur selon l'une quelconque des revendications 13 à 14, dans lequel la couche de nitrure d'élément III est **caractérisée par** une courbe d'intensité de diffraction de rayons X des plans cristallographiques {11-22} en fonction de l'angle d'incidence du faisceau de rayons X sur ces plans présentant une largeur à mi-hauteur inférieure à 400 secondes d'arc.

16. Matériau semi-conducteur selon l'une quelconque des revendications 13 à 15, ledit matériau présentant une densité de dislocations inférieure ou égale à 1,3×10⁸ cm⁻², de préférence encore inférieure à 7×10⁷ cm⁻², et/ou présentant une densité de centres non radiatifs mesurée par cathodoluminescence inférieure ou égale à 1,1×10⁸ cm⁻², de préférence encore inférieure à 5×10⁷ cm⁻², et/ou présentant une densité de fautes d'empilements déterminée par une mesure par microscopie électronique en transmission inférieure ou égale à 1×10³ cm⁻¹, de préférence inférieure ou égale à 70 cm⁻¹.

## Patentansprüche

1. Verfahren zur Herstellung eines Halbleitermaterials, das eine halbpolare Schicht aus Nitrid von Elementen der 3. Hauptgruppe einschließt, ausgehend von einem Ausgangssubstrat (4), das eine Vielzahl von Nuten (40) einschließt, die periodisch um einen Abstand L2 beabstandet sind, wobei jede Nut (40) eine erste geneigte Flanke (41) mit kristallographischer Orientierung C (0001) und eine zweite geneigte Flanke (42) mit unterschiedlicher kristallographischer Orientierung einschließt, wobei eine erste geneigte Flanke einer Nut und eine zweite geneigte Flanke einer benachbarten Nut eine Zinne (43) bilden, wobei der Scheitelpunkt der Zinne mit einer Maske bedeckt ist, wobei das Verfahren folgende Phasen umfasst:
- Bilden (2) von ersten Kristallen (5) aus Nitrid von Elementen der 3. Hauptgruppe auf den ersten geneigten Flanken (41) der Nuten (40), wobei die Wachstumsparameter der Kristalle (5) aus Nitrid von Elementen der 3. Hauptgruppe angepasst sind, um ein seitliches Wachstum der Kristalle zu fördern,
o wobei das Wachstum zunächst dreieckige Hohlräume (52) induziert, die zwischen dem Substrat und zwei benachbarten Nitridkristallen von Elementen der 3. Hauptgruppe gebildet werden, wobei ein dreieckiger Hohlraum eine Basis, zwei Wände und einen Vertex umfasst, wobei die Basis dem Substrat entspricht, eine Wand einem ersten Nitridkristall von Elementen der 3. Hauptgruppe entspricht, die andere Wand dem ersten benachbarten Nitridkristall von Elementen der 3. Hauptgruppe entspricht und der Vertex dem Beginn der Überschneidung zwischen den beiden benachbarten Kristallen entspricht, wobei das Vorhandensein der Maske ein parasitäres Wachstum auf der von der Maske bedeckten Fläche verhindert,
o und dann eine Überlappung zwischen den benachbarten Kristallen (5) aus Nitrid von Elementen der 3. Hauptgruppe induziert, um längliche Hohlräume (53) zu bilden, die am Vertex beginnen und über den dreieckigen Hohlräumen auf Höhe der Überlappungsbereiche zwischen den ersten Kristallen (5) in der Ebene der Begegnung zwischen den ersten Kristallen (5) angeordnet sind, am Schnittpunkt zwischen zwei benachbarten, überlappenden ersten Kristallen;
- Bilden (3) einer zweidimensionalen Schicht aus Nitrid von Elementen der 3. Hauptgruppe auf den zuvor gebildeten Kristallen (5, 6) aus Nitrid von Elementen der 3. Hauptgruppe.

2. Verfahren nach Anspruch 1, ferner umfassend eine Phase (2bis), in der zweite Kristalle (6) auf den ersten Kristallen (5) gebildet werden, wobei die Wachstumsparameter der zweiten Kristalle (6) aus Nitrid von Elementen der 3. Hauptgruppe so angepasst sind, dass sie ein seitliches Wachstum der zweiten Kristalle fördern, sodass eine Überlappung zwischen den benachbarten zweiten Kristallen (6) aus Nitrid von Elementen der 3. Hauptgruppe induziert wird und Hohlräume (63) auf Höhe der Überlappungsbereiche der zweiten Kristalle (6) gebildet werden.

3. Verfahren nach einem der Ansprüche 1 bis 2, ferner umfassend eine Phase (1) des Texturierens des Ausgangssubstrats (4), wobei die Phase (1) einen Schritt des Bildens der Vielzahl von Nuten (40) in dem Ausgangssubstrat (4) umfasst.

4. Verfahren nach Anspruch 3, wobei der Schritt des Bildens der Vielzahl von Nuten folgende Teilschritte umfasst:
- Aufbringen einer dielektrischen oder metallischen Maske (45) mit einer Dicke zwischen 200 nm und 100 Mikrometern mit einer Periode L2, die Öffnungen (44) einschließt,
- Glühen des Ausgangssubstrats (4) mit der Maske bei einer Temperatur von über 900 °C unter einer Atmosphäre, die Ammoniak NH3 und/oder ein Dihydrogen-Distickstoff-Gemisch H2/N2 umfasst, vor dem chemischen Gravieren in einem Säurebad,
- Gravieren des Ausgangssubstrats (4) durch die Öffnungen (44) der Maske (45), indem das Ausgangssubstrat (4) in ein Säurebad eingebracht wird, um die Nuten (40) zu bilden.

5. Verfahren nach Anspruch 4, wobei die Parameter des Schritts des Gravierens des Substrats (4) angepasst sind, um Nuten (40) mit einer größeren Breite als die ursprünglichen Öffnungen (44) zu bilden, dank des seitlichen Abriebs unter der Maske, um abgeriebene Bereiche zu bilden, wobei die Nuten jeweils eine erste geneigte Flanke (41) mit kristallographischer Orientierung C (0001) und eine zweite geneigte Flanke (42) mit kristallographischer Orientierung einschließen, die sich von einer Ebene C (0001), beispielsweise einer Ebene (1101) im Fall von Saphir r, unterscheidet.

6. Verfahren nach Anspruch 5, wobei die Teile der Maske, die über die abgeriebenen Bereiche hinausragen, durch ein Reinigungsverfahren entfernt werden, das eine Behandlung in einem Ultraschallbad umfasst, sodass das Substrat (4) nach Abschluss des Reinigungsverfahrens an der Oberfläche Maskenstreifen (43) mit im Wesentlichen vertikalen Flanken und Nuten (40) umfasst.

7. Verfahren nach einem der Ansprüche 1 bis 6, wobei die Phase (2) des Bildens erster Kristalle (5) folgende Schritte umfasst:
- Ablagern (22) einer Pufferschicht aus Nitriden von Elementen der 3. Hauptgruppe durch Dampfphasenepitaxie von metallorganischen Verbindungen MOVPE aus einer Schicht aus Nitrid von Elementen der 3. Hauptgruppe bei einer Temperatur von weniger als 750 °C;
- thermisches Glühen (23) der Pufferschicht bei einer Temperatur über 950 °C in einer Wasserstoff umfassenden Atmosphäre, um die Festphasenmigration der Pufferschicht zur ersten geneigten Flanke (41) mit Orientierung C jeder Nut zu bewirken und so erste Keime mit kristallographischer Orientierung C (0001) auf den ersten Flanken (41) der Nuten (40) zu bilden.

8. Verfahren nach Anspruch 7, wobei die Phase (2) des Bildens erster Kristalle einen Schritt (24A) des Wachsenlassens der ersten Kristalle (5) auf den ersten Keimen umfasst, und wobei der Schritt (24A) des Wachsenlassens der ersten Kristalle bei einer Temperatur zwischen 900 °C und 1 300 °C bei einem Druck zwischen 0,2×10⁵ Pa und 1×10⁵ Pa durchgeführt wird.

9. Verfahren nach Anspruch 8, wobei die Phase (2) des Bildens der ersten Kristalle einen Schritt des orientierten Wachstums (24B) umfasst, um eine Wachstumsrate der ersten Kristalle entlang kristallographischer Ebenen (0001) zu fördern, die höher ist als die Wachstumsraten der ersten Kristalle (5) entlang der Ebenen senkrecht zu (0001), wie kristallographische Ebenen (112̅0).

10. Verfahren nach Anspruch 2, wobei die Phase (2bis) des Bildens von zweiten Kristallen (6) aus Nitrid von Elementen der 3. Hauptgruppe folgende Schritte umfasst:
- Ablagern einer zweiten SiNx-Schicht (25) auf den bereits vorhandenen ersten Kristallen (5) durch Exposition gegenüber Silan und NH3 bei einer Temperatur von mehr als 950 °C,
- Ablagern (26), bei einer Temperatur von weniger als 750 °C, einer zweiten Pufferschicht aus Nitriden von Elementen der 3. Hauptgruppe auf der zweiten SiNx-Schicht,
- thermisches Glühen (27) der zweiten Pufferschicht bei einer Temperatur von mehr als 950 °C in einer Wasserstoff umfassenden Atmosphäre, um eine Festphasenmigration der Pufferschicht zu den Flächen a (112̅0) und c (0001) der Kristalle (5) zu bewirken, und dadurch zweite Keime auf den Flächen a (112̅0) und c (0001) der ersten Kristalle (5) zu bilden.

11. Verfahren nach Anspruch 10, wobei die Phase (2bis) des Bildens von zweiten Kristallen (6) einen Schritt (28A) des Wachsenlassens der zweiten Kristalle (6) auf den zweiten Keimen umfasst, der bei einer Temperatur zwischen 900 °C und 1 300 °C, einem Druck zwischen 0,2×10⁵ Pa und 1×10⁵ Pa durchgeführt wird.

12. Verfahren nach Anspruch 11, wobei die Phase (2bis) des Bildens der zweiten Kristalle (6) einen Schritt des orientierten Wachstums (28B) umfasst, um eine Wachstumsrate der zweiten Kristalle (6) entlang kristallographischer Ebenen (0001) zu fördern, die höher ist als die Wachstumsraten der zweiten Kristalle (6) entlang der Ebenen senkrecht zu (0001), wie kristallographische Ebenen (112̅0).

13. Halbleitermaterial, einschließlich einer halbpolaren Nitridschicht von Elementen der 3. Hauptgruppe, die auf einem exogenen Substrat epitaxial aufgebracht ist, wobei das Halbleitermaterial eine halbpolare Nitridschicht von Elementen der 3. Hauptgruppe umfasst, die koaleszierte Nitridkristalle von Elementen der 3. Hauptgruppe (5, 6) einschließt, wobei die benachbarten Nitridkristalle von Elementen der 3. Hauptgruppe (5, 6) einander überlappen, wobei das Halbleitermaterial Folgendes umfasst:
dreieckige Hohlräume, die zwischen dem Substrat und zwei benachbarten Nitridkristallen von Elementen der 3. Hauptgruppe gebildet sind, wobei ein dreieckiger Hohlraum eine Basis, zwei Wände und einen Vertex umfasst, wobei die Basis dem Substrat entspricht, eine Wand einem ersten Nitridkristall von Elementen der 3. Hauptgruppe entspricht, die andere Wand dem ersten benachbarten Nitridkristall von Elementen der 3. Hauptgruppe entspricht, und der Vertex dem Beginn der Überschneidung zwischen den beiden benachbarten Kristallen entspricht, und eine zweidimensionale Schicht aus Nitrid von Elementen der 3. Hauptgruppe auf den Kristallen, wobei das Material **dadurch gekennzeichnet ist, dass** es Folgendes umfasst:
längliche Hohlräume (53, 63), die vom Vertex aus beginnen und über den dreieckigen Hohlräumen in der Ebene der Begegnung zwischen den Kristallen (5) am Schnittpunkt zwischen zwei benachbarten Kristallen angeordnet sind, und wobei sich jeder längliche Hohlraum (53, 63) senkrecht zu den überlappenden Bereichen zwischen den Kristallen erstreckt.

14. Halbleitermaterial nach Anspruch 13, wobei sich jeder längliche Hohlraum (53, 63) in einer Ebene erstreckt, die mindestens die Ebene überlagert, die durch die kristallographische Facette (0001) des Substrats definiert ist.

15. Halbleitermaterial nach einem der Ansprüche 13 bis 14, wobei die Nitridschicht von Elementen der 3. Hauptgruppe durch eine Kurve der Röntgenbeugungsintensität der kristallographischen Ebenen { 11-22} in Abhängigkeit des Einfallswinkels des Röntgenstrahls auf diese Ebenen gekennzeichnet ist, die eine Breite auf halber Höhe von weniger als 400 Bogensekunden aufweist.

16. Halbleitermaterial nach einem der Ansprüche 13 bis 15, wobei das Material eine Versetzungsdichte von weniger als oder gleich 1,3×10⁸ cm⁻², vorzugsweise noch weniger als 7×10⁷ cm⁻², aufweist, und/oder eine durch Kathodolumineszenz gemessene Dichte von nicht strahlenden Zentren von weniger als oder gleich 1,1×10⁸ cm⁻², vorzugsweise noch weniger als 5×10⁷ cm⁻², und/oder eine durch eine Messung mittels Durchstrahlungselektronenmikroskopie bestimmte Dichte von Stapelfehlern von weniger als oder gleich 1×10³ cm⁻¹, vorzugsweise weniger als oder gleich 70 cm⁻¹, aufweist.

## Claims

1. A method for manufacturing a semiconductor material including a semi-polar III-nitride layer from a starting substrate (4) including a plurality of grooves (40) periodically spaced apart by a distance L2, each groove (40) including a first inclined flank (41) having a crystallographic orientation C (0001) and a second inclined flank (42) having a different crystallographic orientation, a first inclined flank of a groove and a second inclined flank of an adjacent groove forming a castellation (43), the top of the castellation being covered with a mask, the method comprising the step of:
- forming (2) first III-nitride crystals (5) on the first inclined flanks (41) of the grooves (40), the growth parameters of the III-nitride crystals (5) being adapted to favour lateral growth of said crystals,
o the growth first inducing triangular cavities (52) formed between the substrate and two adjacent III-nitride crystals, a triangular cavity comprising a base, two walls and a vertex, the base corresponding to the substrate, a wall corresponding to a first III-nitride crystal, the other wall corresponding to said adjacent first III-nitride crystal, and the vertex corresponding to the start of the intersection between the two adjacent crystals, wherein the presence of the mask avoids parasitic growth on the surface covered with the mask,
o then, inducing an overlap between the adjacent III-nitride crystals (5) in order to form elongated cavities (53) extending from the vertex and arranged above the triangular cavities in line with the overlapping areas between the first crystals (5) in the meeting plane between the first crystals (5), at the intersection between two first adjacent overlapping crystals;
- forming (3) a two-dimensional III-nitride layer on the III-nitride crystals (5, 6) formed beforehand.

2. The method according to claim 1, which further comprises a phase (2bis) consisting in forming second crystals (6) on the first crystals (5), the growth parameters of the second III-nitride crystals (6) being adapted to favour lateral growth of said second crystals such as to induce an overlap between the adjacent second III-nitride crystals (6) and to form cavities (63) in line with the overlapping areas of the second crystals (6).

3. The method according to any one of claims 1 to 2, which further comprises a phase (1) consisting in texturing the starting substrate (4), said phase (1) including a step consisting in forming the plurality of grooves (40) in the starting substrate (4).

4. The method according to claim 3, wherein the step consisting in forming the plurality of grooves comprises the sub-steps of:
- depositing a dielectric or metallic mask (45), the thickness of which is between 200 nm and 100 micrometres, having a period L2 including openings (44),
- annealing the starting substrate (4) containing the mask at a temperature greater than 900°C under an atmosphere comprising ammonia NH3 and/or a dihydrogen-dinitrogen H2/N2 mixture, prior to chemical etching in an acid bath,
- etching the starting substrate (4) through the openings (44) of the mask (45), by introducing the starting substrate (4) in an acid bath to form the grooves (40).

5. The method according to claim 4, wherein the parameters of the step of etching the substrate (4) are adapted to form grooves (40) of a width greater than the initial openings (44), thanks to lateral abrasion under the mask to form abraded areas, said grooves each including an inclined first flank (41) having a crystallographic orientation C (0001) and a second inclined flank (42) having a crystallographic orientation different from a plane C (0001), for example a plane (1101) in the case of sapphire r.

6. The method according to claim 5, wherein the parts of the mask overhanging the abraded areas are removed by a cleaning procedure comprising treatment in an ultrasound bath, such that, at the end of the cleaning procedure, the substrate (4) has, on its surface, mask strips (43) with substantially vertical flanks and grooves (40).

7. The method according to any one of claims 1 to 6, wherein the step (2) which consists in forming first crystals (5) comprises the steps of:
- depositing (22) a III-nitride buffer layer by metal organic vapour phase epitaxy MOVPE of a III-nitride layer at a temperature less than 750°C;
- thermally annealing (23) the buffer layer at a temperature greater than 950°C under atmosphere comprising hydrogen such as to bring about the solid phase migration of the buffer layer to the first inclined flank (41) of orientation C of each groove and thereby forming first seeds having a crystallographic orientation C (0001) on the first flanks (41) of the grooves (40).

8. The method according to claim 7, wherein the phase (2) consisting in forming first crystals comprises a step (24A) consisting in growing the first crystals (5) on the first seeds, and wherein the step (24A) consisting in growing the first crystals is implemented at a temperature between 900°C and 1 300°C, at a pressure between 0.2×10⁵ Pa and 1×10⁵ Pa.

9. The method according to claim 8, wherein the phase (2) consisting in forming first crystals comprises a step of oriented growth (24B) to favour a growth rate of the first crystals along crystallographic planes (0001) greater than the growth rates of the first crystals (5) along the planes perpendicular to (0001), such as the crystallographic planes (1120).

10. The method according to claim 2, wherein the phase (2bis) consisting in forming second III-nitride crystals (6) comprises the steps consisting in:
- depositing a second SiNx layer (25) on the pre-existing first crystals (5), by exposure to silane and NH3, at a temperature greater than 950°C,
- depositing (26), at a temperature less than 750°C, a second III-nitride buffer layer on the second SiNx layer,
- thermally annealing (27) the second buffer layer at a temperature greater than 950°C under an atmosphere comprising hydrogen such as to bring about the solid phase migration of the buffer layer to the faces a (1120) and c (0001) of the crystals (5), and to thereby form second seeds on the faces a (1120) and c (0001) of the first crystals (5).

11. The method according to claim 10, wherein the phase (2bis) consisting in forming second crystals (6) comprises a step (28A) consisting in growing the second crystals (6) on the second seeds, implemented at a temperature between 900°C and 1 300°C, at a pressure between 0.2×10⁵ Pa and 1×10⁵ Pa.

12. The method according to claim 11, wherein the phase (2bis) consisting in forming the second crystals (6) comprises a step of oriented growth (28B) to favour a growth rate of the second crystals (6) along crystallographic planes (0001) greater than the growth rates of the second crystals (6) along the planes perpendicular to (0001), such as crystallographic planes (1120).

13. A semiconductor material including an epitaxial semi-polar III-nitride layer on an exogenous substrate, the semiconductor material having a semi-polar III-nitride layer including coalesced III-nitride crystals (5, 6), the adjacent III-nitride crystals (5, 6) overlapping, said semiconductor material comprising:
triangular cavities formed between the substrate and two adjacent III-nitride crystals, a triangular cavity comprising a base, two walls and a vertex, the base corresponding to the substrate, a wall corresponding to a first III-nitride crystal, the other wall corresponding to said adjacent first III-nitride crystals, and the vertex corresponding to the start of the intersection between the two adjacent crystals, and a two-dimensional III-nitride layer on said crystals, the material being **characterised in that** it comprises:
elongated cavities (53, 63), extending from the vertex and arranged above the triangular cavities in the meeting plane between the crystals (5), at the intersection between two adjacent crystals, and wherein each elongated cavities (53, 63) extends perpendicular to the overlapping areas between the crystals.

14. The semiconductor material according to claim 13, wherein each elongated cavity (53, 63) extends in a plane that overhangs at least the plane defined by the crystallographic facet (0001) of the substrate.

15. The semiconductor material according to any one of claims 13 to 14, wherein the III-nitride layer is **characterised by** an X-ray diffraction intensity curve of the { 11-22} crystallographic planes as a function of the angle of incidence of the X-ray beam on these planes having a value at half width of less than 400 arc seconds.

16. The semiconductor material according to any one of claims 13 to 15, said material having a dislocation density less than or equal to 1.3×10⁸ cm⁻², preferably still less than 7×10⁷ cm⁻², and/or having a density of non-radiative centres, measured by cathodoluminescence, of less than or equal to 1.1×10⁸ cm⁻², preferably still less than 5×10⁷ cm⁻², and/or having a stacking fault density, determined by a transmission electronic microscopy measurement, of less than or equal to 1×10³ cm⁻¹, preferably less than or equal to 70 cm⁻¹.
